# EUROPEAN PATENT SPECIFICATION

(11) **EP 4 350 747 B1**
(45) Date of publication and mention of the grant of the patent: **06.08.2025**
(21) Application number: 23194330.9
(22) Date of filing: 30.08.2023
(51) Int. Cl.: H01L 21/48, H01L 23/367, H01L 23/473, H01L 23/42, H01L 23/467, H01L 23/053

(54) **METHODS AND STRUCTURES FOR COUPLING THERMAL DISSIPATING ELEMENTS AND THERMAL COOLING STRUCTURES TO INTEGRATED CIRCUIT DIES**
VERFAHREN UND STRUKTUREN ZUR KOPPLUNG VON WÄRMEABLEITUNGSELEMENTEN UND WÄRMEKÜHLUNGSSTRUKTUREN AN INTEGRIERTE SCHALTUNGSCHIPS
PROCÉDÉS ET STRUCTURES POUR COUPLER DES ÉLÉMENTS DE DISSIPATION THERMIQUE ET DES STRUCTURES DE REFROIDISSEMENT THERMIQUE À DES PUCES DE CIRCUIT INTÉGRÉ

(30) Priority: 05.10.2022 US 202263413401 P; 25.07.2023 US 202318225944
(43) Date of publication of application: 10.04.2024
(73) Proprietor: Google LLC, Mountain View, CA 94043 (US)
(72) Inventor: TANG, Yingshi, Mountain View, CA, 94043 (US); WANG, Yingying, Mountain View, CA, 94043 (US); JAIN, Padam, San Jose, CA, 95139 (US); SAMADIANI, Emad, Mountain View, CA, 94043 (US); UDHAYAKUMAR, Sudharshan Sugavanesh, Mountain View, CA, 94043 (US); IYENGAR, Madhusudan K., Mountain View, CA, 94043 (US)
(74) Representative: Betten & Resch

(56) References cited:
- US-A- 5 292 054
- US-A1- 2005 122 126
- US-A1- 2006 126 308
- US-A1- 2007 039 998

## Description

### CROSS REFERENCE TO RELATED APPLICATIONS

The present application claims the benefit of the filing date of U.S. Provisional Patent Application No. 63/413,401, filed October 5, 2022.

### BACKGROUND

Electronic components such as chip assemblies or integrated circuit (IC) dies are often used in electronic devices, such as tablets, computers, copiers, digital cameras, smart phones, control systems, and automated teller machines, among others. The demand for highperformance electronic devices has led to developments in electronic component designs. For instance, to increase the performance of an electronic component, the size of the electronic component is often decreased, while the number of integrated components (e.g., transistors) within the electronic component is increased. However, the decrease in size and increase in the number of components in the electronic components can lead to thermal management issues, such as overheating. Such overheating may result in device failure or electrical performance deterioration.

US 2007/039998 A1 discloses a column suction-holding head.

US 5,292,054 A discloses a method of manufacturing a heat transfer device, particularly a heat transfer device for cooling electronic components, having a metal plate and a plurality of cylindrical metal pins which are packed relatively densely on the plate and extend perpendicularly therefrom.

US 2005/122126 A1 discloses a vacuum controlled fixture for positioning columns arrayed on a principal face thereof, on sites of an electronic substrate.

US 2006/126308 A1 discloses a cooling apparatus and method of fabrication for facilitating removal of heat from a heat generating electronic device.

### SUMMARY

The claimed subject-matter is defined in the independent claims. The dependent claims define embodiments thereof.

According to aspects of the disclosure, methods and structures for providing thermal dissipating elements on integrated circuit ("IC") dies are disclosed. According to an aspect, thermal dissipating element placement assembly, such as a pin fin placement assembly, along with a vacuum pickup assembly, can be used to assist with simultaneous placement of multiple pin fins with desired profiles on desired locations of the IC die. The pin fin placement assembly may be comprised of one or more plates with a plurality of apertures therein for receiving the pin fins. The pin fin placement assembly can be further incorporated into a thermal cooling structure, which can include a manifold configured to encase the IC die and attached pin fins.

According to an aspect of the disclosure, an assembly for positioning a plurality of thermal dissipating elements on an integrated circuit ("IC") die comprises a thermal dissipating element placement assembly and a vacuum pickup assembly. The thermal dissipating element further comprises a plate body having a first plate and a second plate. The first plate has a first plurality of apertures extending through top and bottom surfaces of the first plate. The second plate may also have a second plurality of apertures extending through top and bottom surfaces of the second plate. Each of the second plurality of apertures may have a diameter that is different than a diameter of each of the first plurality of apertures. The second plurality of apertures may be aligned with the first plurality of apertures. The vacuum pickup assembly may be removably coupled to the thermal dissipating element placement assembly. The vacuum pickup assembly may provide a suction force that holds the plurality of thermal dissipating elements within the first or second plurality of apertures in the plate body and against a surface of the plate body.

According to another aspect of the disclosure, an assembly for positioning thermal dissipating elements on an integrated circuit ("IC") die comprises a thermal dissipating element placement assembly and a vacuum pickup assembly. The thermal dissipating element placement assembly may comprise a top plate, a middle plate, and a lower plate vertically assembled to form a plate body. The middle plate may be movable relative to the top plate and/or the lower plate. A first plurality of apertures may be formed in the top plate; and a second plurality of apertures may be formed in the lower plate. The first and the second plurality of apertures are vertically aligned. The first and the second plurality of apertures may be configured to receive the thermal dissipating elements therein. The thermal dissipating elements may be configured to be disposed on an IC die. The vacuum pickup assembly may be removably coupled to the thermal dissipating element placement assembly. The vacuum pickup assembly may be configured to hold the thermal dissipating elements against at least a portion of the plate body.

According to another aspect of the disclosure, an assembly comprises an integrated circuit ("IC"), a thermal dissipating element placement assembly, a plurality of thermal dissipating elements and a manifold. The IC die may be electrically connected to a printed circuit board ("PCB"). The thermal dissipating element placement assembly may be coupled to the PCB. The thermal dissipating element placement assembly may comprise a plate body having a top surface, a bottom surface, and a plurality of apertures extending through the top and bottom surfaces. The plurality of thermal dissipating elements may be disposed within the plurality of apertures and coupled to a surface of the IC die. The manifold may be coupled to the plate body and the IC die, the manifold configured to provide thermal dissipating of the IC die.

According to another aspect of the disclosure, a method for providing thermal dissipating elements on an integrated circuit ("IC") die comprises providing a thermal dissipating element placement assembly comprising at least one plate and a plurality of apertures extending through a top surface and a bottom surface of the at least one plate; using vacuum suction created by a vacuum pickup assembly to position and removably secure the thermal dissipating elements within the plurality of apertures; and joining the thermal dissipating elements positioned within the plurality of apertures with an IC die. While the thermal dissipating elements are positioned within the thermal dissipating element placement assembly, a bonding material disposed between the thermal dissipating elements and the IC die may be reflowed to bond the thermal dissipating elements to the IC die.

According to an aspect of the disclosure, a method for providing thermal dissipating elements on an integrated circuit ("IC") die comprises providing a pin fin placement assembly with a vacuum pickup assembly coupled thereto; using vacuum suction created by a vacuum pickup assembly to pull a plurality of pin fins into apertures of a first plate of the pin fin placement assembly; and laterally moving the second plate relative to the first and third plates to allow the plurality of pin fins in the apertures of the first plate to be positioned within apertures of the third plate. The pin fin placement assembly includes a first plate, a second plate, and a third plate. The plurality of pin fins may be supported within apertures of the first plate of the pin fin placement assembly by the second plate, which underlies the first plate. While the pin fins remain within apertures of the third plate, the pin fins may be positioned adjacent a rear surface of the IC die. A material disposed between the pin fins and the IC die may be reflowed to bond the pin fins to the IC die, thereby forming a plurality of thermal dissipating elements at the surface of the IC die.

### DESCRIPTION OF THE DRAWINGS

A more complete appreciation of the subject matter of the present technology and the various advantages thereof may be realized by reference to the following detailed description which refers to the accompanying drawings, in which:
FIG. 1 depicts a cross-sectional view of an IC package assembly in accordance with aspects of the disclosure;
FIGS. 2A-2L depict cross-sectional views of an example IC package assembly at different stages of manufacturing an IC die of the IC package assembly using a pin fin placement assembly with vacuum pickup assembly in accordance with aspects of the disclosure;
FIGS. 3A-3H depict cross-sectional views of an example IC package assembly at different manufacturing stages using a pin fin placement assembly with vacuum pickup assembly in accordance with aspects of the disclosure;
FIGS. 4A-4F depict schematic cross-sectional views of an example IC package assembly at different manufacturing stages using a pin fin placement assembly with vacuum pickup assembly in accordance with aspects of the disclosure;
FIGS. 5A-5F depict schematic cross-sectional views of an IC package assembly at different manufacturing stages using a pin fin placement assembly with vacuum pickup assembly in accordance with aspects of the disclosure;
FIGS. 6A-6C depict schematic cross-sectional views of an example IC package with an example thermal cooling assembly at different manufacturing stages;
FIGS. 7A-7C depict schematic cross-sectional views of an example IC package with an example thermal cooling assembly at different manufacturing stages;
FIGS. 8A-8E depict cross-sectional views of an example IC package assembly at different manufacturing stages using a pin fin placement assembly with an example vacuum pickup assembly in accordance with aspects of the disclosure;
FIG. 9A depicts a cross-sectional view of a plurality of thermal dissipating features in accordance with aspects of the disclosure;
FIG. 9B depicts a top view of the plurality of thermal dissipating features of FIG. 9A in accordance with aspects of the disclosure;
FIG. 10A depicts a cross-sectional view of another example of a plurality of thermal dissipating features in accordance with aspects of the disclosure;
FIG. 10B depicts a top view of the plurality of thermal dissipating features of FIG. 10A in accordance with aspects of the disclosure;
FIG. 11 depicts a flow diagram for manufacturing an IC package using a pin fin placement assembly and vacuum pickup assembly in accordance with aspects of the disclosure; and
FIG. 12 depicts a flow diagram for manufacturing an IC package using a pin fin placement assembly and vacuum pickup assembly in accordance with aspects of the disclosure.

### DETAILED DESCRIPTION

The present disclosure relates to methods and structures for enhancing thermal dissipation of IC die assemblies. A thermal dissipation element placement assembly, such as a pin fin placement assembly, along with a vacuum pickup assembly, can be used to position a plurality of thermal dissipating elements on an IC die. In some examples, the pin placement assembly can further be incorporated into a thermal cooling structure, which can include a manifold sufficiently sized to encase the IC die and attached pin fins. The pin fin placement assembly may assist with placement of multiple pin fins with desired profiles on desired locations of the IC die. A vacuum pickup assembly can be concurrently used with the pin fin placement assembly to help with accurate alignment of the pin fins with connections on the IC die. The vacuum pickup assembly may provide a force that can secure the pin fins within plates of the pin fin placement assembly, which can aid in alignment of the pins prior to coupling of the pin fins with the IC die.

The thermal dissipation element placement assembly can include at least one plate with a plurality of apertures designed to secure a plurality of thermal dissipation elements or pin fins therein. A vacuum pickup assembly can include at least a vacuum pickup pump and a vacuum chamber. A suction force generated by the vacuum pickup pump can draw the plurality of pin fins into corresponding apertures in the at least one plate.

In an example where the placement assembly is comprised of a single plate, the plurality of apertures can have an upper portion and a lower portion with differing diameters. The suction force can draw the pin fins into each of the apertures, and in some examples, due to the differing diameters, the pin fins will be held in place within the apertures. While the pin fins remain in place within the pin fin assembly, the pin fins can be aligned with solder connections or the like on an IC die and then bonded to the IC die during a thermal process, such as reflow. In some examples, it may be desired to provide an additional thermal cooling structure to aid with dissipation of heat from the IC die and the surrounding environment. For example, a manifold may be provided to the rear surface of the plate and the plate of the pin fin assembly can be incorporated into the thermal cooling structure. Alternatively, the plate can be removed altogether, and a manifold may otherwise be used to encase the IC die.

In some examples, the placement assembly comprises two plates, an upper plate and a lower plate. The upper plate may include first apertures that are aligned with second apertures in the lower plate. The first apertures may have a diameter that is smaller than the diameter of the second apertures such that at least a portion of the bottom surface of the upper plate overlies the second apertures. Suction force from the vacuum pickup assembly can draw the pin fins into each of the plurality of second apertures, where they will be held against the bottom surface of the upper plate. While the pin fins remain in place within the pin fin assembly, the pin fins can be aligned with solder connections or the like on an IC die and then bonded to the IC die during a thermal process, such as reflow. An additional thermal cooling structure can also be provided to further aid with dissipation of heat from the IC die, as previously discussed.

In still other examples, the placement assembly may comprise three plates: an upper plate, a bottom plate, and a middle plate that is movable relative to the upper plate and the bottom plate. The upper plate can include a first plurality of apertures having a first diameter; the bottom plate can include a second plurality of apertures having a second diameter; and the middle plate can include a third plurality of apertures that have a third diameter. The first, second and third apertures may be aligned with one another, where the first and third diameters are sized to receive the size of pin fins, and the second diameter is smaller than the first and third diameters and need only be large enough to allow for air from the vacuum pickup pump to pass through the second plate. In this regard, the third diameter is smaller than the first diameter, which renders the third apertures incapable of receiving the pin fins therethrough. In this example, force from the vacuum pickup pump can draw pin fins into the first plurality of apertures. The pin fins will be held in place against the middle plate due to the differing diameters. When it is desired to position the pin fins on an IC die, the vacuum pickup assembly may be removed and the pin fins aligned with solder connections on the IC die. Movement of the middle plate in a lateral direction can cause the pin fins to drop down into the third plurality of apertures in the third plate and also the surface of the IC die. While the pins remain in the pin fin assembly, the IC die and pin fins may be reflowed to secure the pin fins to the IC die. An additional thermal cooling structure can also be provided to further aid with dissipation of heat from the IC die, as previously discussed. The pin fin assembly can remain a part of the additional thermal cooling structure or the pin fin assembly can be removed and a manifold positioned to overlie the IC die and attached pin fins. In another example, instead of three plates, a two plate structure may include the first and third plates as a single unitary plate, and the middle plate is movable relative to the single unitary plate.

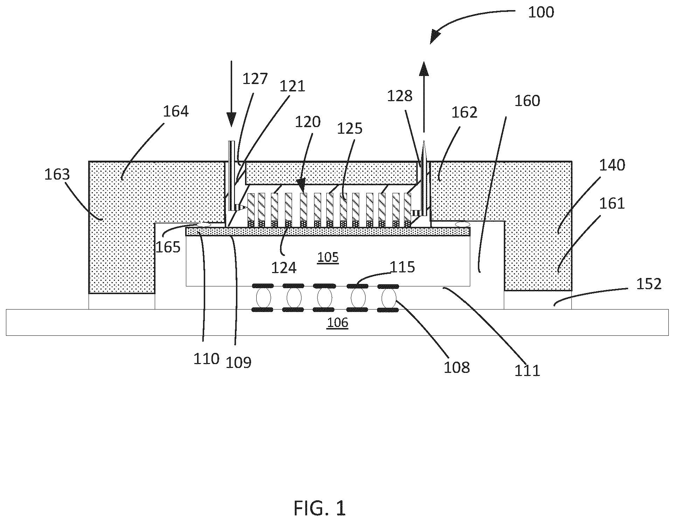

FIG. 1 depicts a cross sectional-view of an IC package 100, including an IC die 105 formed on a printed circuit board (PCB) 106. Although the example depicted in FIG. 1 only illustrates one IC die 105 and one PCB 106, in other examples, an IC package may include any number of IC dies, and any number of PCBs. Further, in other examples, in lieu of a PCB, any other substrates, including a removably and temporarily attached carrier substrate may be used in place of a PCB. Any number of IC dies, devices, or chip assemblies disposed within the IC package 100 may be utilized. In one example, the IC die 105 may be a graphics processing unit (GPU), custom application-specific integrated circuit (ASIC), memory devices, high-bandwidth memory (HBM) components, or any other type of device or stack. In one example, the IC die 105 is disposed on the PCB 106 through a plurality of solder balls 108 arranged in a ball grid array (BGA). Other arrangements and connectors may include contacts arranged in a land grid array (LGA), connector pins arranged in a pin grid array (PGA), etc. In other examples, the IC die 105 may be connected to the PCB through other conductive features capable of forming a conductive connection between the IC die 105 and the PCB 106, such as conductive posts, conductive material, and the like.

In one example, thermal cooling of an IC die or other microelectronic elements or devices can be accomplished using thermal dissipating elements, such as pin fins 125. Pin fins 125 may be coupled to an IC die, such as the rear surface of the IC die, alone or in combination with a surrounding manifold 140 utilized to encase the IC die 105.

A plurality of thermal dissipating elements 120 may be disposed at a first surface 109 of the IC die 105 that may assist in dissipating thermal energy from the IC die 105 when IC die 105 is in operation. In one example, the plurality of thermal dissipating elements 120 may be disposed at the rear surface 109 of the IC die 105 by soldering, or any other suitable process of coupling the thermal dissipating elements 120 to the IC die 105. A second surface 111 is formed substantially in parallel and opposite to the first surface 109 where a plurality of bond pads or device structures 115 may be disposed. A metallization layer 110 may be formed at the rear surface 109 of the IC die 105 to facilitate soldering the plurality of thermal dissipating elements 120 thereon. In one example, the metallization layer 110 may be manufactured from a conductive material, such as copper, aluminum, tungsten, nickel, silver, iron, combinations thereof, alloys thereof, or the like.

In one example, each of the thermal dissipating elements 120 may include a plurality of pin fins 125 coupled to the IC die 105. The pin fin 125 may be disposed at the IC die 105 using a conductive material, such as a solder connection 124, which can include solder paste, solder foil, solder bumps, or the like. Other thermally conductive materials can also be utilized. The solder connections 124 may secure the pin fins 125 to the first surface 109 of the IC die 105 once soldered. In one example, the pin fin 125 may be manufactured from a metallic material possessing thermal dissipation or thermal transmission efficiency. Examples of metallic materials that may be selected to manufacture the pin fin 125 include copper, aluminum, tungsten, gold, silver, combinations thereof, alloys thereof, or the like. In one example, the pin fin 125 may have an aspect ratio, such as a height to diameter ratio, between about 1:1 and 20:1, such as about 10:1 or 5:1.

The thermal dissipating elements 120 can take on different forms and be arranged on the IC die in various configurations. The thermal dissipating features 120 may include, for example, pin fins 125 disposed at the rear surface 109 of the IC die 105 in one or more arrays or matrices. In one example, the plurality of pin fins 125 may have a pitch between about 100 µm and about 500 µm, such as between about 150 µm and about 300 µm, such as about 200 µm. In other examples, the pitch may be less than 100 µm or greater than 500 µm. In still other examples, the pitch may be greater than 100 µm or less than 500 µm.

An optional manifold 140 may also be coupled to the IC die to further enhance thermal cooling of the IC die. In this example, manifold 140 may be coupled to IC die and PCB using known materials or structures. In one example, manifold 140 is attached to IC die using an adhesive material 152. The adhesive material 152 provides a sealing interface between the manifold 140 and the PCB 106. The manifold 140 may include a first sidewall 161 and a second sidewall 163 connected by a ceiling 162, forming a substantially U-shaped body 164 that defines a central cavity 160 on a bottom side of the manifold 140. The central cavity 160 encases IC die 105 when the manifold 140 is placed or mounted on the PCB 106. A sealing member 165 may be utilized to seal the interface where the manifold 150 is in contact with the IC die 105. In one example, the sealing member 165 may be an adhesive material, an O ring, or suitable mechanical attachments that facilitate positioning and securement of the manifold 140 to the IC die 105. A plenum 121 may be defined in the ceiling 162 of the manifold 140. The plenum 121 may allow a cooling medium, including a fluid, air, liquid, or other such cooling material to be introduced therein for temperature control purposes to the IC die 105. The manifold may be comprised of various materials, and in some examples, thermally conductive materials. Aluminum, carbon steel, stainless steel, brass, alloys, and/or plastic compounds are examples of materials that may comprise a manifold.

When in operation, fluid may be supplied from an inlet 127 to circulate throughout the plenum 121 to an outlet 128. In one example, the number and configuration of inlets and outlets can vary, such as an inlet disposed between two outlets, two inlets and two outlets, etc. The fluid as supplied may include liquid, air, or other suitable cooling mediums that may efficiently reduce the temperature of the IC die 105 with which the cooling medium is in direct contact. The thermal dissipating elements 120, such as the pin fins 125, may increase contact surface area when the fluid is in circulation in the plenum 121. The increased contact surface area provided may enhance the cooling performance.

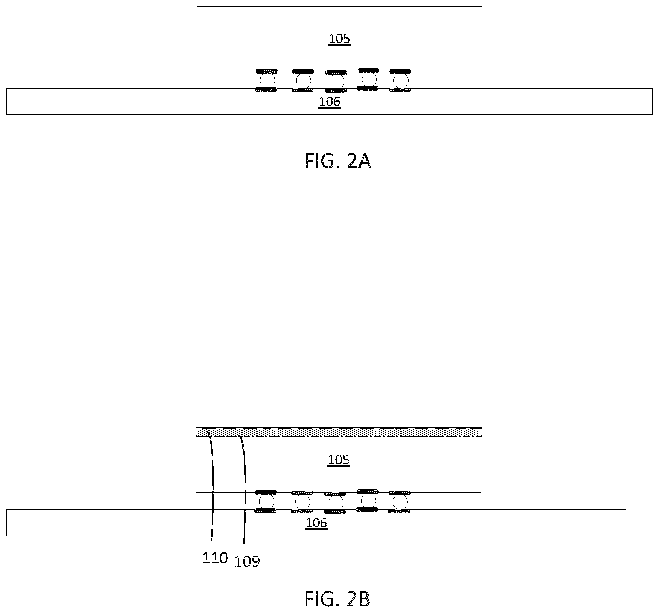

FIGS. 2A-2J depict cross-sectional views of an IC package assembly during different stages of coupling the pin fins 125 to the IC die 105 of FIG. 1, as well as the optional addition of a manifold for use with the IC die 105 during liquid cooling. In FIG. 2A, the IC die 105 is attached to the PCB 106 using an array of solder ball connections 108. After the IC die 105 is soldered, a metallization layer 110 may be disposed or otherwise disposed at the rear surface 109 of the IC die 105, as shown in FIG. 2B. In some examples, the metallization layer 110 may be disposed or otherwise formed at the rear surface 109 of the IC die 105 prior to the soldering of the IC die 105 to the PCB 106. For example, the metallization layer 110 may be deposited or formed on the IC die 105 as part of the manufacturing steps fulfilled by the IC manufacturing facilities prior to shipping to the IC packaging facility to be soldered on the PCB 106.

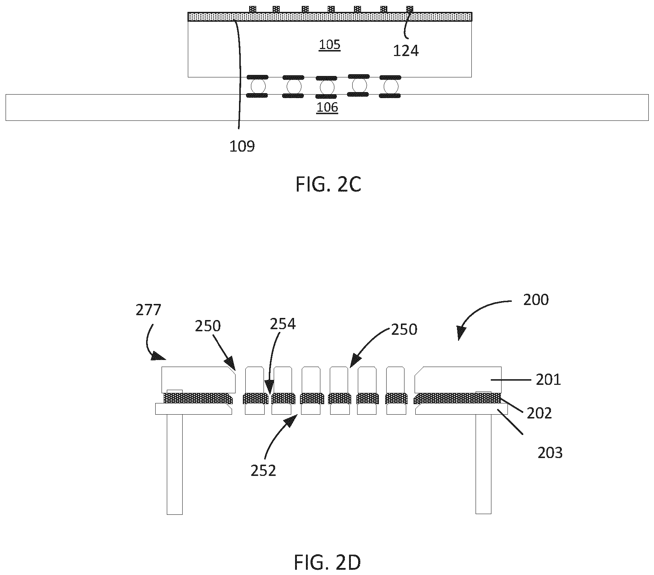

A plurality of the solder connections 124 may be deposited on the rear surface 109 of the IC die 105, such as shown in FIG. 2C. Various processes for depositing solder connections 124 onto the surface of the IC die means may be utilized, such as printing, sputtering, or other deposition methods. Solder connections 124 may facilitate attachment of the pin fins 125 to the surface 109 of the IC die 105 for temperature control when in operation. In other examples, different materials may be used to attach the pin fins to the 125 IC die, such as gold, copper, electrically conductive adhesives, silver-infused high-temperature epoxy, or other means or materials for attaching the pin fins 125 to the IC die 105.

A thermal dissipating element placement assembly may be used to position and secure thermal dissipating elements to the IC die 105. In one example, as shown in FIG. 2D an example pin fin placement assembly 200 may be utilized to arrange the pin fins 125 onto the IC die 105, and in this example directly onto solder connections 124 (FIG. 2C). In one example, the pin fin placement assembly 200 includes a top plate 201, a middle plate 202, and a bottom plate 203 vertically assembled to collectively form a plate body 277. The middle plate 202 may be laterally moveable relative to the top plate 201 and the bottom plate 203. The plates may be comprised of various materials, including, but not limited to, stainless steel, copper, and plastic. Apertures 250 in the top plate 201 align with apertures 252 on the bottom plate 203, as well as apertures 254 on the middle plate 202. The apertures 250, 252, and 254 are configured to allow for the passage of the pin fins 125 and air therethrough, as discussed in further detail herein.

The plate body 277 may be disposed on one or more supporting posts 255. The supporting posts 255 may serve as tooling or alignment pins that will later be placed into alignment holes (not visible in FIG. 2D) formed in the PCB 106, when the pin fin placement assembly 200 is aligned with PCB 106. During this early stage of the manufacturing process, the supporting posts 255 may be free-standing and capable of being operational on any available surface. In other examples, the posts 255 may be removably attached or interconnected with a temporary carrier, such as a platform, another printed circuit board, or the like.

The pin fins 125 that will later be coupled with the IC die 105 may be pre-manufactured metallic structures with desired profiles and configurations. For example, the pin fins 125 may be pre-manufactured metallic structures with desired aspect ratios, such as a particular diameter to height ratio. The profile may be adjusted such that the pin fins 125, when attached to the IC die 105, adequately dispatch heat generated by the IC die to the cooling material.

The dimensions, distributions, and the numbers of the apertures 250 formed in the top plate 201 may be configured to accommodate the dimensions of the pin fins 125. In one example, the dimensions, distributions, and the numbers of the pin fins 125 may be determined based on the amount of thermal energy needed to be dispatched from the IC die 105 where the pin fins 125 are mounted. For example, when a higher thermal flux of thermal energy is desired to be dispatched from the IC die 105, higher numbers or higher placement density of the pin fins 125 may be configured to be formed on the IC die 105. In other examples, the dimensions, distributions, profiles, and the numbers of the pin fins 125 may be configured in any manner.

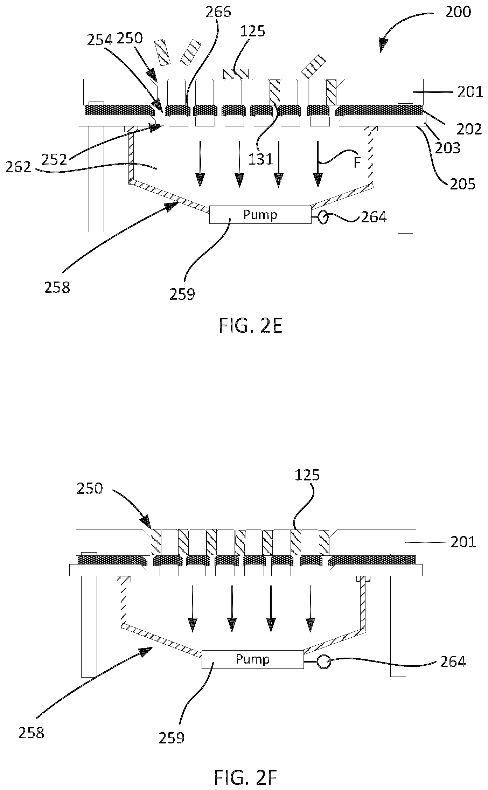

A vacuum pick up assembly may be attached to the pin fin placement assembly 200 to assist with positioning the pin fins 125 within the apertures 250. An example vacuum pickup assembly 258 is schematically illustrated in FIG. 2E and can include at least a vacuum pickup pump 259, a vacuum chamber 262, and an optional vacuum pressure gauge 264. In some examples, the components may be coupled to the bottom surface 205 of the bottom plate 203, but in other examples, one or more of the components may be positioned elsewhere relative to the pin fin placement assembly 200. In operation, the vacuum pickup pump 259 creates a suction force F that can help to draw the pin fins 125 into the apertures 250.

To position a pin fin 125 within the apertures 250 in top plate 201, the vacuum pickup pump 259 creates a suction force F that can help to draw the pin fins 125 into the apertures 250. For example, a plurality of pin fins 125 may be poured in a direction toward the apertures 250 of the top plate 201. Apertures 252 in the bottom plate 203 also serve as vent apertures that will allow the vacuum pickup pump 259 to draw air. Suction force F from the vacuum pickup assembly 258 can help to draw or pull fin pins 125 into each of the apertures 250. In some examples, additional mechanisms or procedures can be utilized in connection with the vacuum pickup pump assembly 258 to help drive the pin fins 125 into the apertures 250 of the top plate 201. Ultrasonic vibrations, mechanical movements, mechanical vibrations, or a brush are nonlimiting examples of such additional mechanisms or procedures. Once the pin fins 125 are placed and filled in the apertures 250 of the top plate 201, redundant pin fins 125 may be removed from the top plate 201.

At least a portion of the middle plate 202 may extend into the apertures 250 to temporarily hold or secure the pin fins 125 in place within the apertures 250. For example, the size of the apertures 254 in the middle plate 202 may be smaller than the size of the apertures 250 in the top plate 201 so as to form a supporting edge or lip 266 that supports at least a portion of the bottom surface 131 of the pin fins 125 and prevents the pin fins 125 from prematurely moving into the apertures 252 of the bottom plate 203.

A vacuum pickup gauge and/or pressure sensor can be implemented within the system to help determine when each of the apertures 250 within the top plate 201 are filled with pin fins 125, as shown in FIG. 2F. For example, the vacuum pressure when all of the apertures 250 are filled with pin fins 125 can be pre-determined. A vacuum pickup gauge 264 can be used to monitor the vacuum pickup pressure during positioning of the pin fins 125 within the apertures. Once the pre-determined vacuum pickup pressure of the vacuum chamber 262 has been achieved, this signifies that each of the apertures 250 in the top plate 201 retain a pin fin 125 therein. This can notify the operator of the system that this stage of the manufacturing process is complete. In some examples, sensors can additionally be used to determine when all of the pin fins 125 are positioned within the top plate 201 and automatically turn off the vacuum pickup assembly 258.

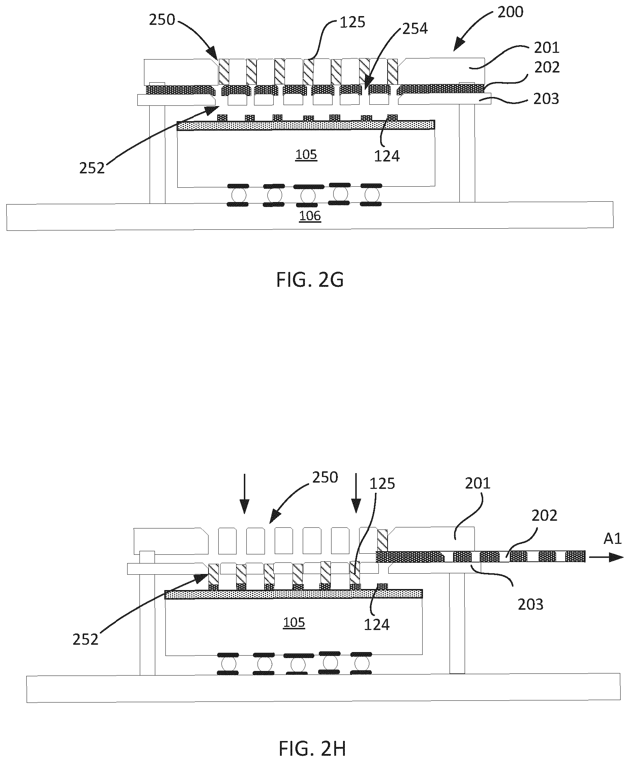

The vacuum pickup assembly 258 can be detached or removed from the pin fin placement assembly 200, as shown in FIG. 2G. The pin fin placement assembly 200 will be coupled to the PCB 106 and IC die 105 (FIG. 2C) to position and secure the pin fins 125 to the IC die 105. In this example, the apertures 250 of the top plate 201, the apertures 254 of the middle plate 202, and the apertures 252 of the bottom plate 203 are aligned with one another, as well as the solder connections 124 disposed at the IC die 105.

As shown in FIG. 2H, the middle plate 202 is laterally movable relative to the top and bottom plates 201, 203, and in this example can be pulled out in a lateral direction, such as the direction shown by arrow A1. Once the middle plate 202 is pulled, the pin fins 125 in the top plate 201 without the support from the middle plate 202 drop down into the apertures 252 formed in the bottom plate 203. The vertical alignment of the apertures 252 in the bottom plate 203 with the apertures 250 formed in the top plate 201 allow the pin fins 125 to be dropped down to a desired position on the IC die 105. In one example, the pin fins 125 are configured to be dropped down to the corresponding solder connection 124 on the IC die 105. Thus, when the middle plate 202 is laterally pulled, the pin fins 125 may be dropped down directly onto the corresponding solder connection 124.

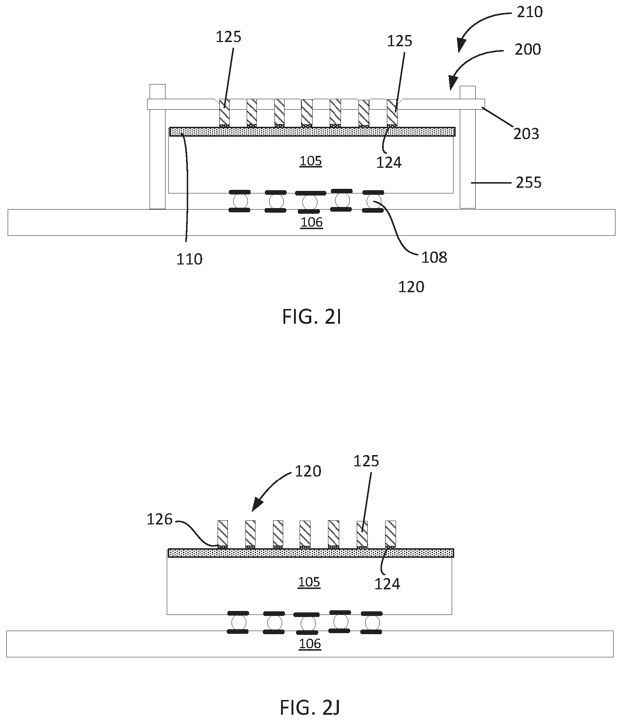

The top plate 201 and middle plate 202 may be dissembled and removed from the pin fin placement assembly 200. As shown in FIG. 2I, the remaining portions of the pin fin placement assembly 200, including the bottom plate 203 and supporting pins 255, along with IC die 105 form an in-process thermal assembly 210 that will undergo thermal treatment processing. In one example, the in-process thermal assembly 210 is placed into a reflow oven, along with PCB 106. Removal of the top plate 201 and/or the middle plate 202 removed from the pin fin placement assembly 200 may reduce the thermal mass during the subsequent thermal treatment process. In other examples, the top plate 201 and the middle plate 202 may remain during the subsequent thermal treatment process. Similarly, in an example where the top plate 201 and bottom plate 203 are formed as a single plate, such plate may remain during reflow.

The thermal treatment process may provide thermal energy to adhere the pin fins 125 onto the solder connection 124 with sufficient and desired adhesion. As illustrated in FIG. 2I, the bottom plate 203 can remain in place during the thermal treatment process to hold the pin fins 125 in place and at desired locations over the rear of the IC die 105 during the reflow process. The holding and support from the bottom plate 203 during the thermal treatment process may assist with joinder of pin fins 125 to the solder connections 124 or on the metallization layer 110 with desired integrity and profile without undesired collapse and deterioration. Additionally, bottom plate 203 can also maintain the pins in place while the solder connections 124 are cured. It is to be appreciated that although not shown in the figures and as known in the art, due to the inherent properties of the reflowed solder connections 124, solder may also be positioned adjacent the edges 126 of pin fins 125 to help further secure the pin fins 125 to IC die 105.

The pin fin placement assembly 200 may be removed from the PCB 106, as shown in FIG. 2J. At this stage, the IC die 105 with thermal dissipating elements 120 can be considered complete. If desired, additional or optional processing may take place. In one example, additional thermally conductive features are provided to enhance thermal cooling of the IC die, as discussed below.

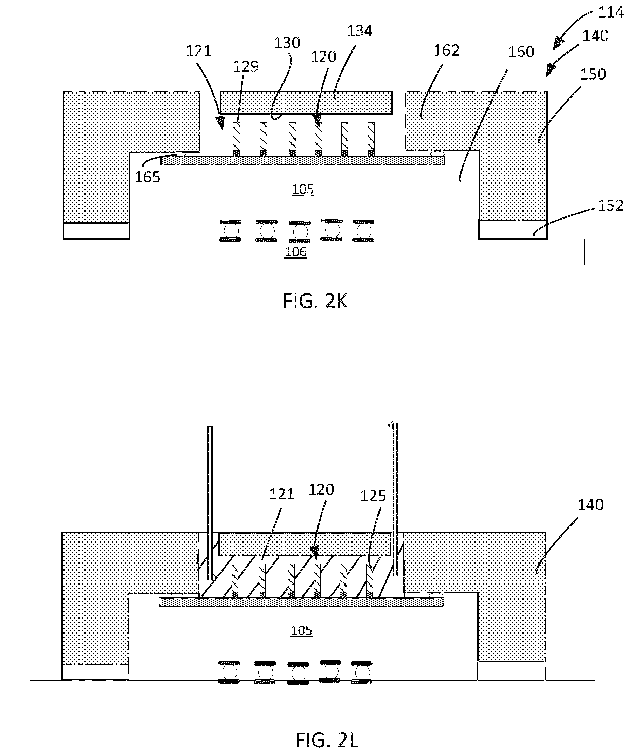

In FIG. 2K, a thermal cooling structure 114, which in this example comprises manifold 140, may be disposed on the PCB 106 and IC die 105. Manifold 140 may be attached to a surface of the PCB 106 using an adhesive material 152. A sealing interface 165 may be used to join manifold 140 to IC die 105, as previously discussed herein. The manifold 140 may be positioned in a manner that allows the central cavity 160 of the manifold 140 to encase the IC die 105 therein while allowing the plurality of thermal dissipating elements 120 to be encased in the plenum 121. The height of the thermal dissipating elements 120 may be controlled in a manner so that a top 129 of the thermal dissipating elements 120 may be maintained spaced apart from a bottom surface 130 of the center portion 134 of the ceiling 162. In other examples, different configurations of the thermal dissipating elements 120 may be utilized to enhance thermal energy circulation and thermal dissipation efficiency. Once the manifold 140 is coupled with the PCB 106 and IC die 105, the installation of the manifold 150, is then considered completed.

In FIG. 2L, once the manifold 140 is in place, cooling material may be supplied to the plenum 121 to facilitate temperature control of the IC die 105. As shown, cooling material, as previously discussed herein, may flow through inlet 127, into plenum 121 and through the plurality of thermal dissipating elements 120 disposed on the IC die 105, and finally out of the manifold 140 through the outlet 128.

As the numbers, profiles, and distributions of the pin fins 125 formed on the IC die 105 may include different configurations and requirements, a pre-manufactured pattern provided from the pin fin placement assembly 200 may assist in placing the pin fins 125 on the IC die efficiently and precisely. For example, in conventional manners, individually placing the pin fins 125 on the IC die often results in inaccurate alignment, time consuming, and positional errors during the process of the placement. By utilizing the pin fin placement assembly 200, the desired patterns, distributions, profiles and configurations of the pin fins 125 may be pre-molded and formed in the top and bottom plates of the pin fin placement assembly 200. Thus, once the pin fins are driven and placed into the apertures formed in the pin fin placement assembly 200, the pin fins are ready to be positioned and bonded to the IC die with the desired distribution and patterns, thus providing a time-efficient and precise placement of the pin fins on the IC die with minimum errors. Thus, the pin fin placement assembly enables large amounts of pin fins, such as tens of thousands or more, to be simultaneously placed on the IC die, instead of being individually placed, positioned, and coupled to the IC die.

Although FIGS. 2A-2L are shown as being one continuous process, it is to be appreciated that different vendors can perform different parts of the assembly process, or different aspects of the assembly process can take place at difference times, such that not all of the processes disclosed in FIGS. 2A-2L needs to take place at the same time. For example, FIGS. 2A-2C disclose preparation of a chip assembly 210 and one or more of FIGS. 2A-2C may be prepared by one manufacturer. The placement of pin fins 125 onto the IC die, such as disclosed in FIGS. 2D-2J may be performed by the same or another manufacturer. And further thermal processing to add the manifold can be performed by a same or different manufacturer.

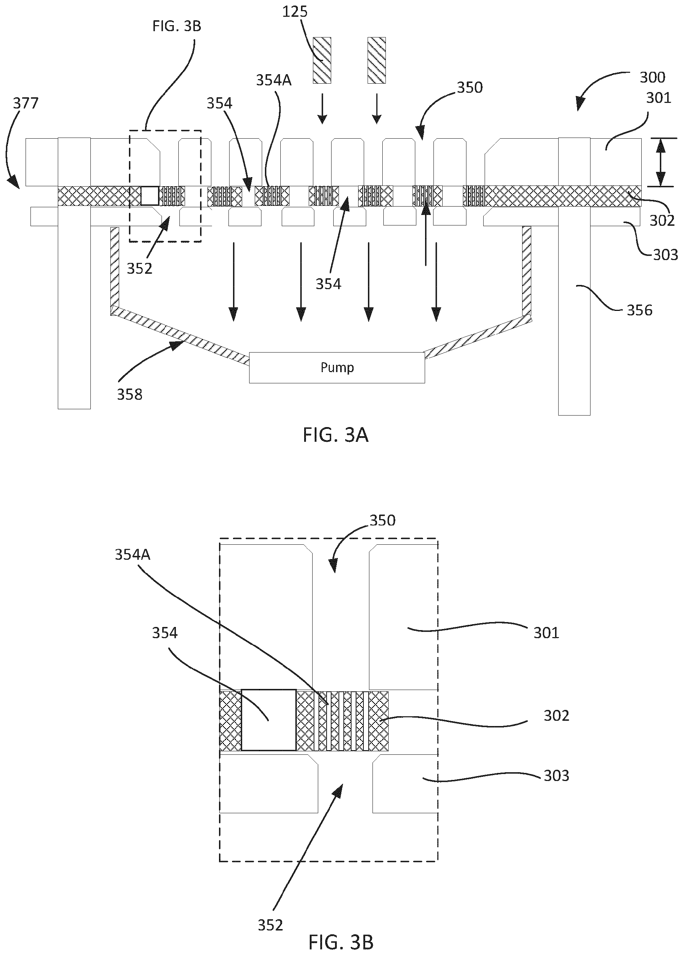

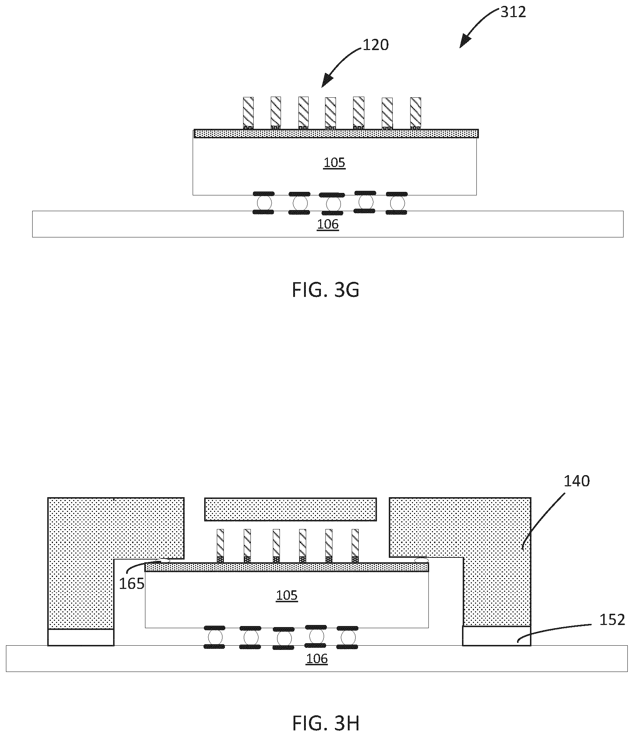

FIG. 3A-3F depict enlarged cross-sectional views of another example pin fin placement assembly 300 with an attached vacuum pickup assembly 358 that can be used to position pin fins 125 on an IC die (FIG. 1). As shown in FIG. 3A, pin fin placement assembly 300 includes a top plate 301, a middle plate 302, a bottom plate 303, and supports, such as tooling pins 356. The combination of the top plate 301, middle plate 302, and the bottom plate 303 form a plate body 377. The pin fin placement assembly 300 is similar to the prior version and differs due to the configuration of the middle plate 302, and particularly the addition of vent apertures 354A in the middle plate 302, along with the apertures 354 that are sized to receive the pin fins 125 therethrough. Middle plate 302 may be movable relative to the top plate 301 and/or the bottom plate 303, and in this example is laterally movable relative to the top plate 301 and bottom plate 303.

During the initial stages of assembly, middle plate 302 will be used to support pin fins 125, while pin fins 125 are positioned within the apertures 350 of top plate 301. As shown in FIGS. 3A-3B, vent apertures 354A are initially aligned with the apertures 350 of the top plate 301 and the apertures 352 of the bottom plate 303. The vent apertures 354A of middle plate 303 are significantly smaller than the pin fins 125, which allows for the pin fins 125 to be supported by the middle plate 302 when the vent apertures 354A are aligned with the apertures 350 in top plate 301. The vent apertures 354A provide an air passageway that allows for suction from the vacuum pickup assembly 358 to draw the pin fins 125 into the apertures 350 of the top plate 301. When the vent apertures 354A are aligned with the apertures 350 of the top plate 301 and apertures 352 of the bottom plate 303, the larger apertures 354 in the middle plate 302 will be offset from the apertures 350, 352 in the top and bottom plates 301,303. (See FIG. 3B.)

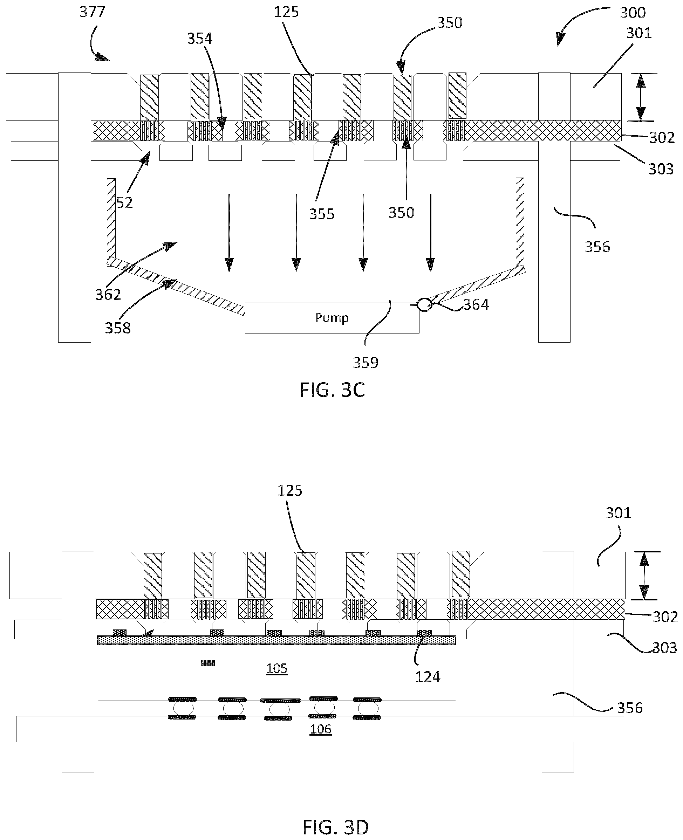

As shown in FIG. 3C, the vacuum pickup assembly 358 can help to draw or pull the pin fins 325 into the pin fin assembly 300. The vacuum pickup assembly 358 can include similar components as described herein, including a vacuum pickup pump 359 which can create a suction force, vacuum chamber 362, and vacuum pressure gauge 364. Each of the pin fins 125 can be pulled into the apertures 350 by vacuum suction created by the vacuum pickup assembly 358, and in this example vacuum pickup pump 359. As in the previous example, once the pin fins 125 are positioned within the apertures 350 of the top plate 301, the vacuum pickup assembly 358 can be removed.

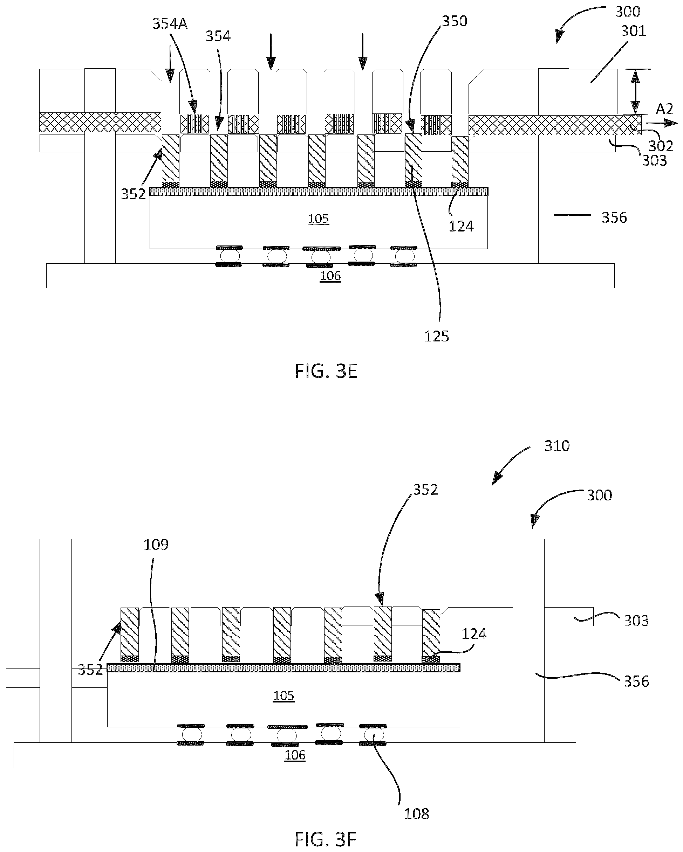

The pin fin placement assembly may overlie IC die 105 with solder connections 124. Apertures 352 in bottom plate 303 may be aligned with solder connections 124, as shown in FIG. 3D. Middle plate 302 may be moved laterally relative to the top plate 301 and bottom plate 303. In the example shown in FIG. 3E, the middle plate 302 only needs to be slightly moved or shifted to allow for the pin fins 125 to drop therethrough. In this example, the middle plate 302 is slightly moved to the right in the direction of arrow A2, so that the apertures 354 within middle plate 302 are aligned with apertures 350 of the top plate 301 and apertures 352 of the bottom plate 303. In other examples, the middle plate 302 may be moved in a direction opposite to the arrow A2 in order to align apertures 354 in the middle plate 302 with apertures 350 and 352. Lateral movement of middle plate 302 causes the vent apertures 354A to be offset from the apertures 350 of the top plate 301 and apertures 352 of the bottom plate 303. Larger apertures 354 in middle plate 302 will then be aligned with apertures 350 of the top plate and apertures 352 of the bottom plate, such that the middle plate 302 no longer supports the pin fins 125. Pin fins 125 within the top plate 301 may then drop down into apertures 352 of the bottom plate 303 and contact the solder connection 124 formed on the IC die 105, while still being held in place within the pin fin assembly 300, and in this example, the apertures 352 of bottom plate 302.

Once the pin fins 125 are aligned with solder connections 124, the top plate 301 and middle plate 302 can be removed from the pin-fin placement assembly 300. As shown in FIG. 3F, the remaining portions of the pin fin assembly, which in this example includes bottom plate 303 and supports 356, along with IC die 105 with overlying pin fins 125, solder connections 124, solder balls 108 and PCB 106 form an in-process thermal unit 310, that can undergo further thermal processing. For example, the in-process thermal assembly 310, may be placed into a reflow oven to undergo the reflow process, as previously described herein. During the reflow process, the pin fins 125 will be retained in place within apertures 352 of bottom plate 303. Upon completion of thermal processing, pin fins 125 will be secured to IC die 105, and in this example, soldered and disposed on a rear surface 109 of IC die 105. This configuration therefore allows for slight lateral movement of the middle plate 302, instead of requiring that an end of the middle plate 302 is pulled out relative to the top and bottom plates 301, 303, as depicted in the examples of FIGS. 2A-2F. By such configuration, a relatively small apparatus footprint and small operational space are required.

With reference to 3G, at the conclusion of thermal processing, the pin fin assembly 300 may be removed, so as to leave behind an IC die package 312. As shown, the IC die package 312 includes IC die 105, thermal dissipating elements 120 bonded to the IC die 105, a printed circuit board 106. The IC Die package may be further processed. For example, as shown in FIG. 3H, additional thermal processing may take place. A thermal cooling structure 114, which in this example comprises manifold 140, as previously described herein, may be coupled to the IC die 105 so as to encase the IC die 105, as shown in FIG. 3H and described herein. In other examples, instead of the thermal processing shown in in FIG. 3H, the chip package 312 can be provided for distribution to a third party who may implement additional thermal or other processes specific to or compatible with systems of the third party.

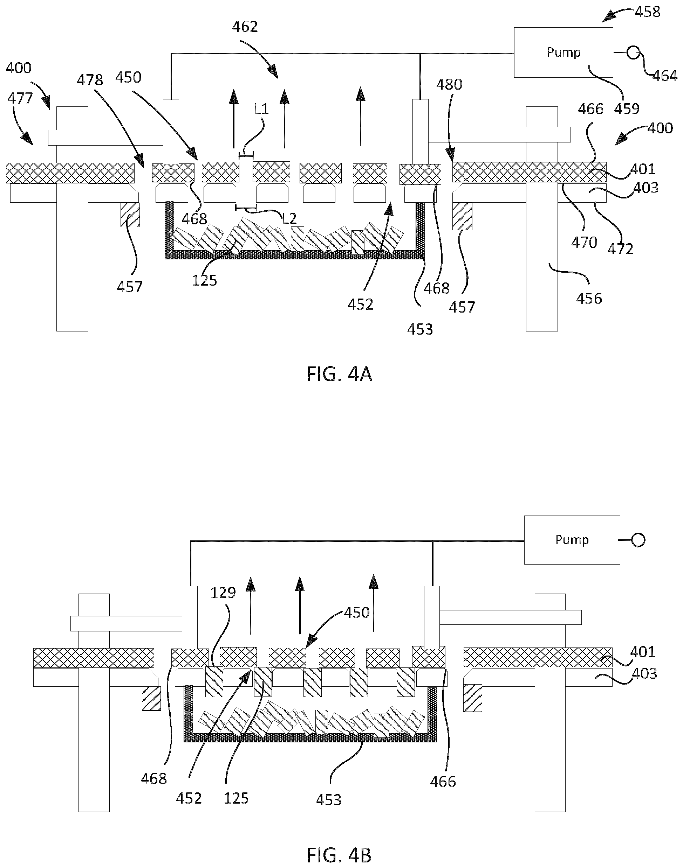

FIGS. 4A-4E depict cross-sectional view of another example of the pin fin placement assembly 400 with a vacuum pickup assembly. This configuration differs from the previous examples of FIGS. 2D-2F and FIGS. 3A-3C, to the extent that vacuum pickup suction is used to pull the pin fins 125 upwards into the pin fin placement assembly 400, instead of vacuum suction pulling the pin fins 125 downward into the pin fin placement assembly 400. As shown in FIG. 4A, pin fin placement assembly 400 includes a top plate 401, a bottom plate 403, and pin fin assembly frame supports 456. The top plate 401 includes a top surface 466, a bottom surface 468 and a plurality of apertures 450 extending through the top and bottom surfaces 466, 468. Similarly, bottom plate 403 includes a top surface 470, a bottom surface 472 and plurality of apertures 450 extending through top and bottom surfaces 470, 471. The plates of the pin fin placement assembly (including top plate 401 and bottom plate 403) may be comprised of various materials, including, without limitation, stainless steel, Cu, plastic, and the like.

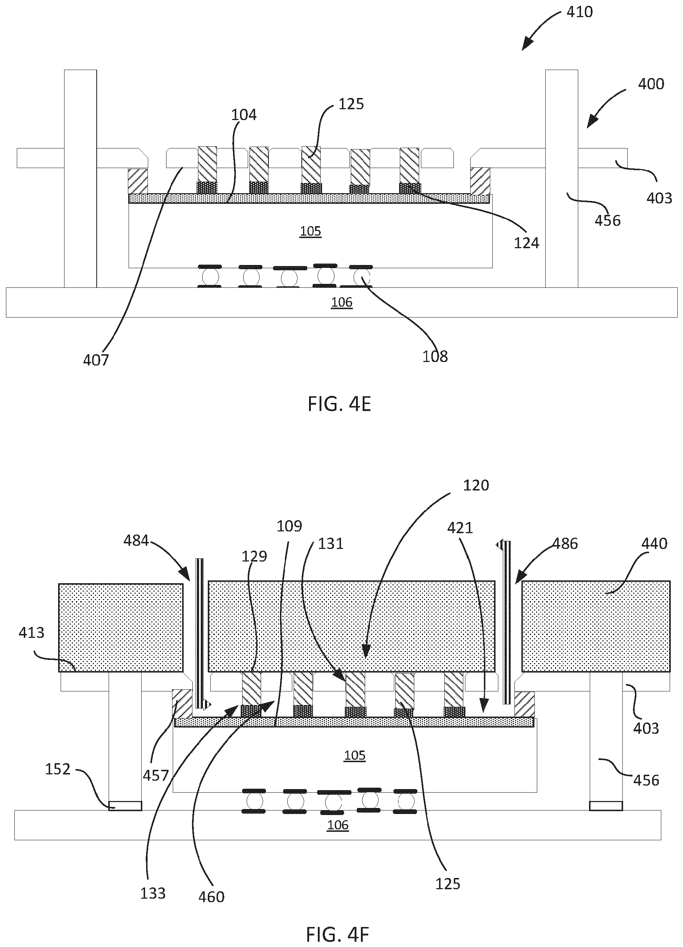

The attached vacuum pickup assembly 458 may include a vacuum pickup pump 459, a vacuum chamber 462, and a vacuum pressure gauge 464. Additionally, a pin fin receptacle 453 may be attached to the pin fin placement assembly 400. Cooling chamber supports 457 may be coupled to a bottom surface 472 of the bottom plate 403. As will be discussed in more detail herein, cooling chamber supports 457 can be used to provide sidewalls that create a plenum between the IC die and the bottom plate 403. In some examples, cooling chamber supports 457 can be comprised of a thermally conductive material, and in some examples may be the same material that will comprise the manifold 440. (*See* FIG. 4F.) In other examples, the cooling chamber supports 457 may be separately formed and coupled to the bottom plate at a later stage. Alternatively, the cooling chamber supports 457 can be provided at the IC die and later coupled to the pin fin placement assembly 400. In another example, the cooling chamber supports 457 can be comprised of one or more sealing elements, such as, but not limited to, an O-ring

The top plate 401 and the bottom plate 403 may collectively form the plate body 477. As shown, apertures 450 in the top plate 401 align with apertures 452 in the bottom plate 403. At least some of the apertures 450 in the top plate 401 may have a diameter or length L1 that is smaller or less than the diameter or length L2 of the aperture 452 in the bottom plate 403. In this example, all of the apertures 450 may have a diameter or length L1 that is smaller than the diameter of the aperture 452 on the bottom plate 403. As shown, bottom surfaces 468 of top plate 401 will extend partially across apertures 452 in bottom plate 403. The arrangement of the smaller apertures 450 in the top plate 401 allows the vacuum pickup assembly 458 to draw air, while securing pin fins 125 within the apertures 452 of bottom plate 403.

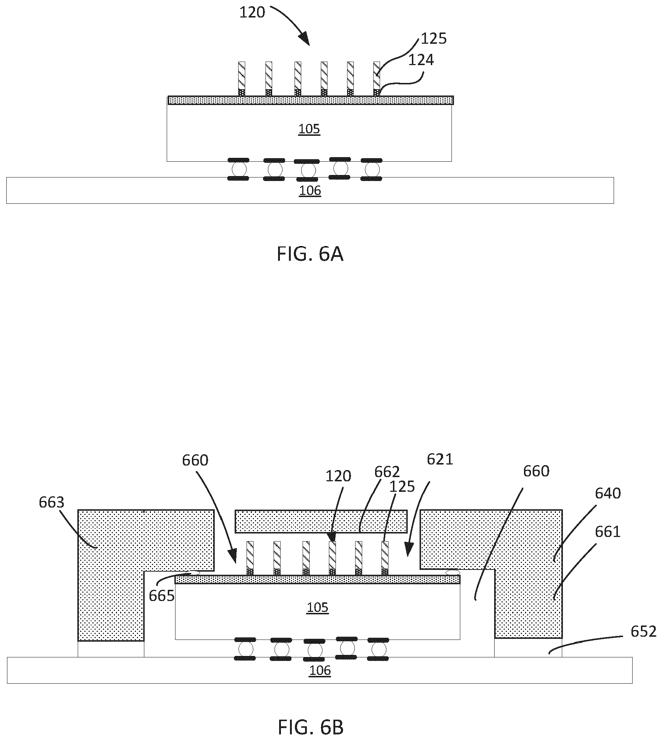

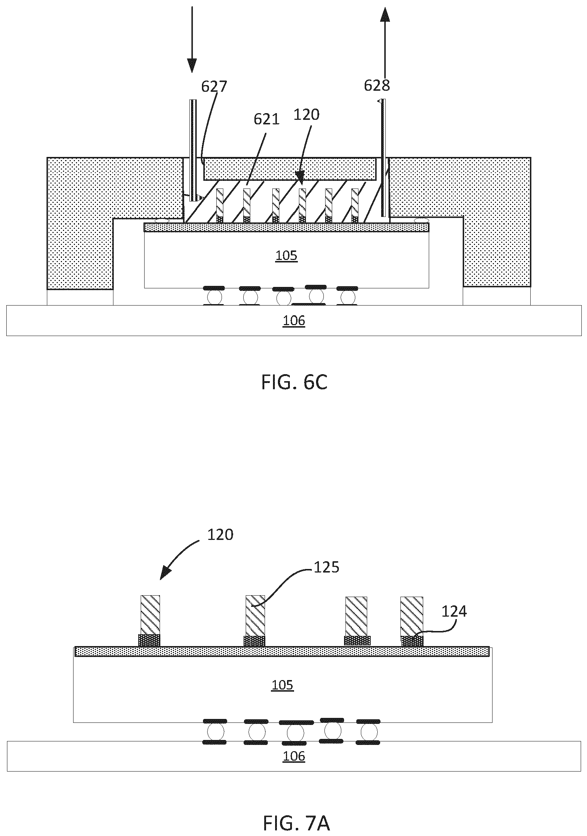

In some pin fin placement assembly 400 configurations, the plate body 477 may further include a liquid cooling inlet 478, as well as a liquid cooling outlet 480 that will allow for cooling liquid to pass therethrough, as discussed in more detail below. The liquid cooling inlet 478 may be formed by alignment of at least one aperture 450 in top plate 401 and one aperture 452 in bottom plate 403, and the liquid cooling outlet 480 may be formed by alignment of an aperture 450 in top plate 401 and an aperture 452 in bottom plate 403. The liquid cooling inlet 478 and liquid cooling outlet 480 may be positioned in an area that is outside of the vacuum pickup chamber 462. In this example, the liquid cooling inlet 478 and liquid cooling outlet 480 are positioned outside of the vacuum chamber 462 and pin fin receptacle 453, such that the liquid cooling inlet 478 and liquid cooling outlet 480 will not be used to retain any pin fins 125 therein. It is to be appreciated that in other examples where the pin fin placement assembly will not be incorporated into a final thermal cooling structure, such as thermal cooling structures subsequently discussed with regard to FIGS. 6A-6C and 7A-7C, a liquid cooling inlet 478 and liquid cooling outlet 480 can be omitted from the plate body 477 of the pin fin assembly 400, if desired.

A plurality of pin fins can be provided or available for use with pin fin placement assembly. For example, a pin fin receptacle 453 that houses multiple pin fins 125 may be attached to the pin fin placement assembly 400. In some examples, the pin fins 125 are not arranged in any specific configurations and are loosely held within the pin fin receptacle 453. In other examples, the pin fins may be pre-aligned with apertures 452 and placed into an upright position. The pin fins 125 can be comprised of any material that can thermally conduct heat away from the IC die 105. Examples of materials forming the plurality of pin fins 125 include copper, aluminum, tungsten, gold, silver, combinations thereof, or alloys thereof. A vacuum pickup chamber 462 can overlie top plate 401.

As shown in FIG. 4B, when the vacuum chamber assembly is operating, vacuum pickup suction will cause the pin fins 125 to move upwards into the apertures 452 of bottom plate 403. As shown, pin fins 125 will be releasably secured within apertures 452 of bottom plate 403 due to the force F of the vacuum pickup suction. The top surfaces 129 of the pin fins 125 within apertures 452 will be held against the bottom surface 468 of top plate 401. The portions of the bottom surface 468 of top plate 401 that overlies apertures 452 of the bottom plate 403 will prevent pin fins 125 from being pulled into aperture 450 of top plate 401 and into vacuum pickup chamber 462.

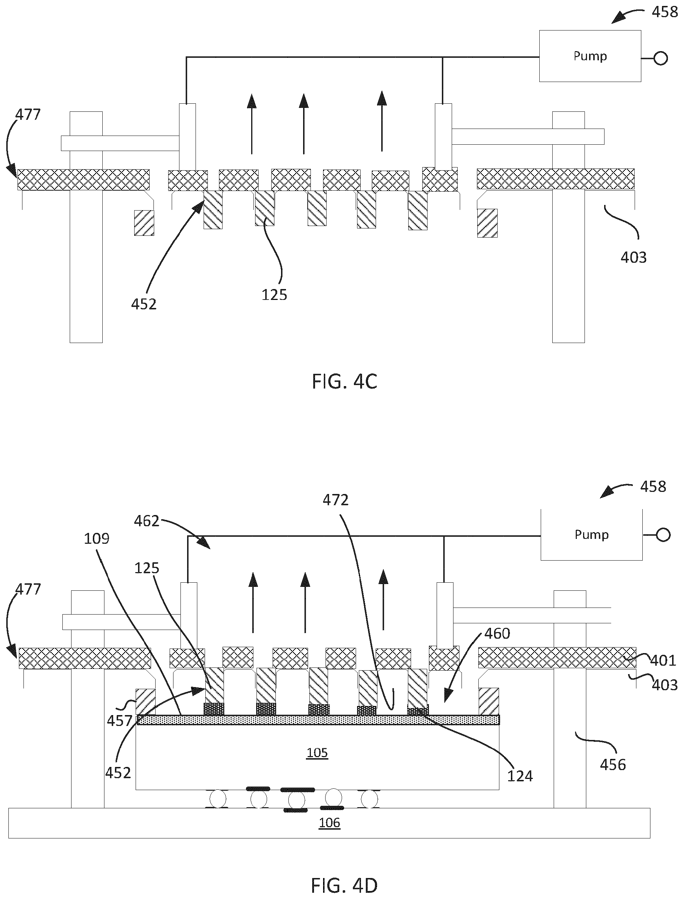

While the pin fins 125 are secured within the plate body 477, the pin fin receptacle 453 may be removed, as shown in FIG. 4C. Vacuum suction from the vacuum pickup assembly 458 will continue to hold the pin fins 125 within apertures 452 of bottom plate 403, while further processing takes place. The pin fins 125 may then be joined to another microelectronic device or assembly. In one example, pin fins 125 may be coupled to IC die 105 and PCB 106, as shown for example in FIG. 4D and discussed with regard to FIGS. 2A-2C. Pin fins 125 may be aligned with solder connections 124, as the IC die 105 and PCB 106 are joined to bottom plate 403. While the solder connections 124 are in the process of being aligned with the pin fins 125, the vacuum pickup assembly 458 will remain active and secure the pin fins 125 within the plate body 477, and in this example, apertures 452 of bottom plate 403. Cooling chamber supports 457 may also be coupled to IC die 105, and in this example, chamber supports 457 are attached to the rear surface 104 of IC die. This creates an enclosed interior cavity 460 between the bottom surface 472 of bottom plate 403 and the rear surface 109 of IC die 106. As will be discussed below, cooling chamber supports 457 can additionally create a plenum through which cooling material may pass through.

The vacuum pickup assembly 458 may be removed, along with the top plate 401, once pin fins 125 are aligned with solder connections 124. As shown in FIG. 4E, the remaining portions of pin fin placement assembly 400, which in this example includes the bottom plate 403 and supports 456, along with the IC die 105 and PCB 106, form an in-process thermal assembly 410, as shown in FIG. 4E. The in-process thermal assembly 410 may be subjected to further thermal processing. In this example, in-process thermal assembly 410 may be reflowed to secure pin fins 125 to IC die 105 through solder connections 124. Since the pin fins 125 remain in place within the remaining structure of the pin fin placement assembly 400, and in this example, within the apertures 452 of bottom plate 403, proper alignment of each of the pin fins 125 to the solder connections 124 can be maintained throughout the reflow and curing process. IC die 105 can be further secured to the PCB 106 through reflow of solder balls 108.

After reflow, further processing to enhance thermal dissipation of IC die 105 may be implemented. For example, as shown in FIG. 4F, a manifold 440 may be joined to the rear surface 413 of bottom plate 403. An adhesive material or other mechanism (e.g., screws) or material for securing manifold 440 to the bottom plate 403 can be utilized. Manifold 440 further overlies the top surfaces 129 of the plurality of thermal dissipating elements 120, such as pins 125, so that the top portions 131 of the plurality of thermal dissipating elements 120 will be encased and only a lower portion 133 of each of the plurality of thermal dissipating elements 120 will be exposed. In other examples, different configurations of the thermal dissipating elements 120 may be utilized to enhance thermal energy circulation and thermal dissipation efficiency.

Once the manifold 140 is coupled to the PCB 106 and IC die 105, the installation of the manifold 140, bottom plate 403, and the thermal dissipating elements 120 is then considered completed. As shown, a plenum 421 is created within the space or cavity 460 formed between bottom plate 403 and bottom surface 109 of IC die 105 such that fluid may travel through a manifold inlet 484, through the plenum 421 and pin fins 125, and through manifold outlet 486, so as to facilitate temperature control and cooling of the IC die 105. In this example, the manifold 440, bottom plate 403, and cooling chamber supports 457 collectively form a thermal cooling structure 414 that can maintain the pin fins 125 in place and prevent liquid coolant pressure from breaking the solder joints. The cooling structure 414 may remain in place during liquid cooling and throughout the life of the IC die 105.

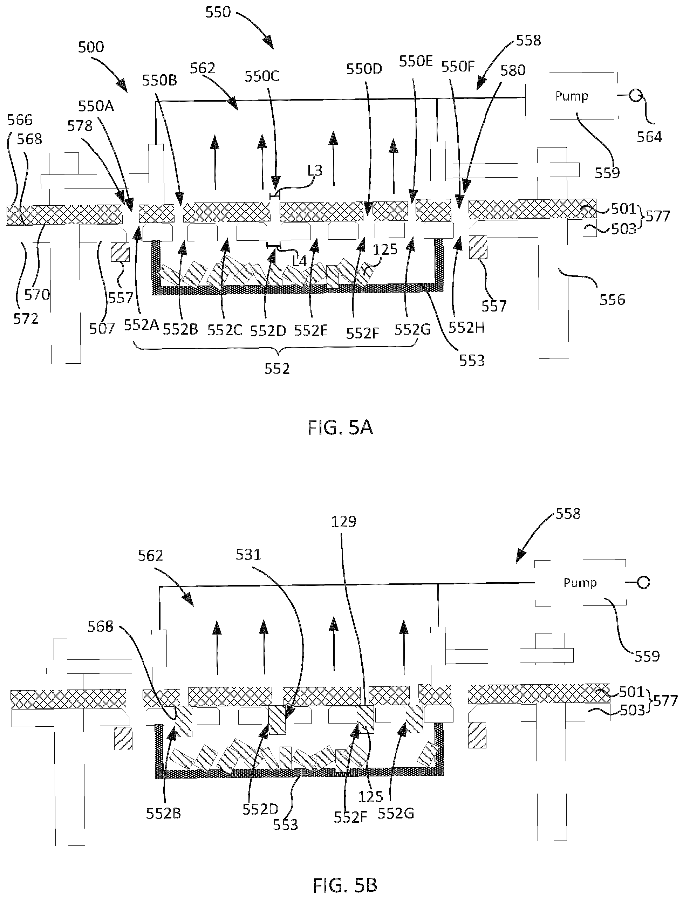

FIGS. 5A-5E depict cross-sectional views of another example of the pin fin placement assembly 500 with an example vacuum pickup assembly. This configuration differs from the previous example described in FIGS. 4A-4E to the extent that not all of the openings in the top plate 505 are aligned with openings in the bottom plate 503, which in some examples, allows for a different distribution of liquid coolant across and around pin fins 125. Referring to FIG. 5A, in this example, pin fin placement assembly 500 includes a top plate 501, a bottom plate 503, and pin fin assembly frame supports 556. The top plate 501 includes a top surface 566, a bottom surface 568 and a plurality of apertures 550A, 550B, 550C, 550D, 550E, 550F (collectively "top plate apertures 550") extending through the top and bottom surfaces 566, 568. Similarly, bottom plate 503 includes a top surface 570, a bottom surface 572 and plurality of apertures 552A, 552B, 552C, 552D, 552E, 552F, 552G, 552H (collectively "bottom plate apertures 552") extending through top and bottom surfaces 570,572. A pin fin receptacle 553 may be attached to the bottom plate 503 and a vacuum pump assembly 558 may be attached to the top plate 501. The top plate 501 and the bottom plate 503 may collectively form the plate body 577. Additionally, cooling chamber supports 557 may be coupled to a bottom surface 570 of bottom plate 503. The vacuum pickup assembly 558 may include a vacuum pickup pump 559, a vacuum chamber 562, and a vacuum pressure gauge 564, but additional components or alternative components may also be included.

While in some examples all of the top plate apertures 550 may be aligned with bottom plate aperture 552, in other examples fewer than all of the top plate apertures 550 may be aligned with the bottom plate apertures 552. Apertures 550A, 550B, 550C, 550D, 550E, 550F in the top plate align with respective apertures 552A, 552B, 552D, 552F, 552G, 552H. None of the top plate apertures 550 correspond to apertures 552C, 552E in the bottom plate. Rather, a bottom surface 568 of top plate 501 completely covers or overlies apertures 552C and 552E in bottom plate 503, such that vacuum suction will be unable to draw pin fins 125 up into the apertures 552C and 552E. Aperture 550A in the top plate 501 and aperture 552A in the bottom plate 503 collectively form a liquid cooling inlet 578, and apertures 550F in the top plate and 552H in the bottom plate collectively form a liquid cooling outlet 580.

All of the top plate apertures 550 may be smaller than the bottom plate 503 apertures 552. For example, apertures that are positioned within the vacuum chamber 562, such as apertures 550B, 550C, 550D, 550E, may have a length L3 that is smaller than the length L4 of corresponding apertures 552B, 552D, 552F and 552G in the bottom plate 503. As shown, bottom surfaces 568 of the top plate adjacent apertures 550B, 550C, 550D, and 550E in top plate 501 will extend partially across apertures 552B, 552D, 552F and 552G in bottom plate 503. The arrangement of the smaller apertures 550B, 550C, 550D, and 550E in the top plate 501 allows the vacuum pickup assembly 558 to draw air and secure pin fins 125 within the apertures 552B, 552D, 552F, and 552G of the bottom plate 503. In some examples, all of the top plate apertures 550 may be smaller than the bottom plate apertures 552.

A plurality of pin fins 125 can be provided within the pin fin receptacle 553. The pin fins 125 can be comprised of any material that can thermally conduct heat away from the IC die 105. Examples of materials forming the plurality of pin fins 125 include copper, aluminum, tungsten, gold, silver, combinations thereof, or alloys thereof. A pin fin vacuum chamber 562 can overlie top plate 501. As shown in FIG. 5B, vacuum pickup suction generated by the vacuum pump 559 of vacuum pickup assembly 558 will draw or pull the pin fins 125 up into the apertures 552B, 552D, 552F, 552G of bottom plate 503. The portions of the bottom surface 568 of the top plate 501 that overlie apertures 552B, 552D, 552F, 552G in bottom plate 503 will prevent pin fins 125 from being pulled into the top plate apertures 550 and into vacuum chamber 562. As shown, pin fins 125 will be secured within apertures 552B, 552D, 552F, 552G of bottom plate 503 due to vacuum suction securing the top portions 531 of the pin fins 125 against the bottom surface 568 of top plate 501.

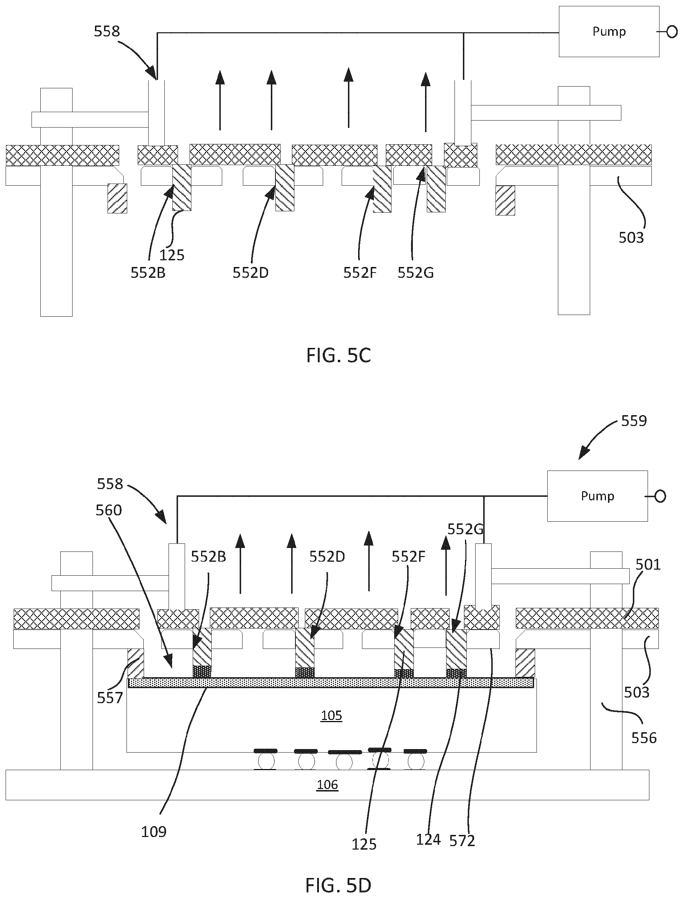

Once the pin fins 125 are secured in place within plate body 577, and in this example, within apertures 552B, 552D, 552F, and 552G of bottom plate 503, the pin fin receptacle 553 may be removed, as shown in FIG. 5C. Vacuum suction from the vacuum pickup assembly 558 may continue to secure the pin fins 125 within apertures 552B, 552D, 552F, 552G of bottom plate 503, while further processing takes place.

With the pin fin receptacle 553 removed, the pin fins 125 may be joined to another microelectronic device or assembly. In one example, pin fins 125 may be coupled to IC die 105 and PCB 106. As shown in FIG. 5D, pin fins 125 may be aligned with solder connections 124, as the IC die 105 and PCB 106 are joined to bottom plate 503. While solder connections 124 are in the process of being aligned with pin fins 125, the vacuum pickup assembly 558 will remain active and secure pin fins 125 within the apertures 552B, 552D, 552F, 552G of bottom plate 503. The cooling chamber supports 557 may also be coupled to the rear surface 109 of the IC die 105. This creates an enclosed interior cavity 560 between the bottom surface 572 of the bottom plate 503 and the rear surface 109 of the IC die 105.

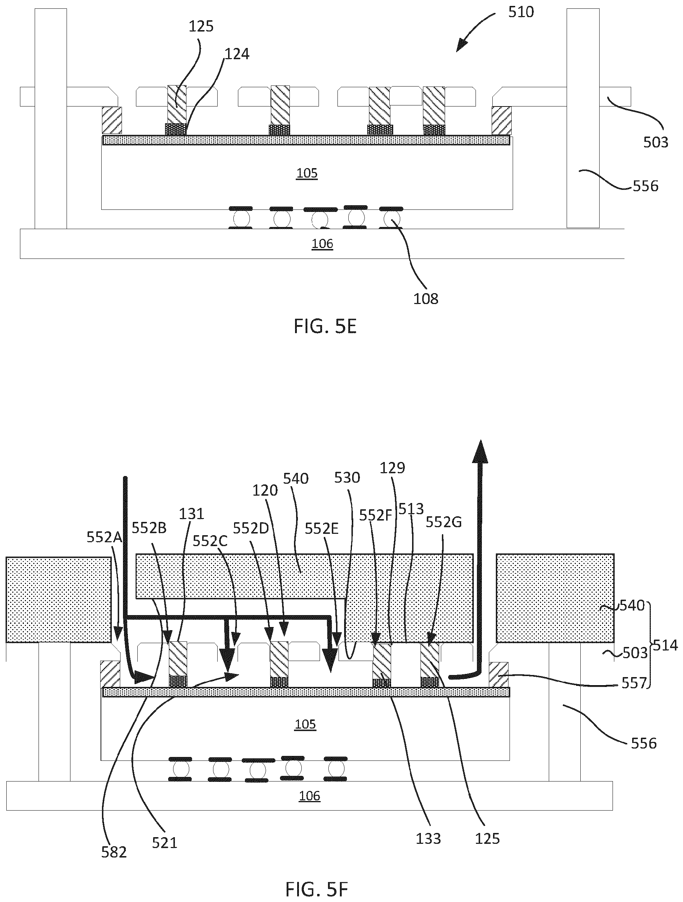

Once pin fins 125 are aligned with solder connections 124, vacuum pickup assembly 559 may be removed, along with top plate 501. As shown in FIG. 5E, the remaining portions of pin fin placement assembly 500, which in this example includes the bottom plate 503 and supports 556, in addition to IC die 105 and PCB 106, form an in-process thermal assembly 510. The in-process assembly 510 may undergo thermal processing and in some examples, may be reflowed to secure pin fins 125 to IC die 105. With the remaining portions of the pin fin placement assembly 500 remaining in place during further thermal processing, proper alignment of each of the pin fins 125 to the solder connections 124 can be accomplished. Solder balls 108 may also be reflowed in this step, although may have already been reflowed at an earlier stage.

After reflow, further thermal processing may take place. In one example, as shown in FIG. 5F, a manifold 540 may be joined to the rear surface 513 of bottom plate 503. An adhesive material or other mechanism (e.g., screws) or material for securing manifold 540 to the bottom plate 503 can be utilized. Manifold 540 overlies all of the top surfaces 129 of the plurality of thermal dissipating elements 120, which include pin fins 125. In this example, part of bottom surface 530 of manifold 540 is shown spaced apart from pin fins 125 in apertures 552A, 552B, 552C, 552D, and 552E, so as to create channels or passageways for liquid coolant within the pin fin assembly to be disposed around exposed surfaces of pin fins 125. As shown, bottom surface 582 of manifold 540 overlying pin fins 125 within apertures 525F and 552G of bottom plate 503 is directly connected to and covers top surfaces 129 of the plurality of pin fins 125, such that only a lower portion 133 of each of the plurality of thermal dissipating elements 120 will be exposed. As in the previous example, the combination of the manifold 540, bottom plate 503, and cooling chamber supports 557 may collectively form a thermal cooling structure 514.

The different configurations of the thermal dissipating elements 120 may be utilized to enhance thermal energy circulation and thermal dissipation efficiency. Once the manifold 540 is secured to the PCB 106 and IC die 105, the installation of the cooling structure 514 is then considered completed. With the manifold 550 in place, a cooling medium may be supplied to the plenum 521 to facilitate temperature control and cooling of the IC die 105 through the plurality of thermal dissipating elements 120 disposed on the IC die 105. For example, fluid, air, liquid, or other such cooling material to be introduced therein to the IC die 105 and thermal cooling elements 120. Variation of the pin apertures allows for a different flow of cooling liquid prevents liquid coolant pressure from breaking the soldering joints, so as to provide long term reliability. In contrast to the prior example, cooling liquid may now flow over the top surfaces 129 of thermal dissipating elements 120, including pin fins 125 secured within apertures 552B and 552D of bottom plate 503, as well as travel through apertures 552A, 552C, 552E in bottom plate 503. In this example, the cooling structure 514, including manifold 540 and remaining portions of pin fin assembly 500, can remain in place during liquid cooling. This allows for the pin fins 125 to remain accurately positioned and secured to IC die 105 during liquid cooling, thereby preventing liquid coolant pressure from breaking the solder joints. This cooling structure 514 may remain in place and be utilized throughout liquid cooling. It is to be appreciated that the interior cavity formed by the combination of the manifold 540 and bottom plate 503 can vary widely and according to desired specifications.

The prior examples described with regard to FIGS. 4A-4F and 5A-5F discuss incorporating the remaining components of the respective pin fin placement assemblies 400, 500, namely respective bottom plates 403, 503, along with the respective manifolds 440, 540, and cooling chamber supports 447, 547 into the respective final thermal conductive structures 414, 514. In alternative examples, it may be desired to instead remove the remaining components of the pin fin placement assembly altogether so that the pin fin placement assembly does not structurally remain as a part of the thermal conductive structure, and only the manifold forms a thermal conductive structure. For example, after reflow of the in-process thermal assembly 410 described in FIG. 4E, instead of proceeding with the manufacturing process shown in FIG. 4F, the remaining components of the pin fin placement assembly 400 can alternatively be removed altogether. For example, as shown in FIG. 6A, this leaves behind the IC die 105, PCB element 106, and the thermally conductive structures 120, including pin fins 125, that are joined to IC die 105 by a solder connection 124.

As shown in FIG. 6B, a manifold, such as manifold 640, maybe joined to the IC die 105 and PC board 106, as previously described herein. The manifold 640 can provide a structure to help thermally dissipate heat from the IC die 105 and the surrounding environment during use. In this example, manifold 640 is utilized to encase the IC die 105, along with the thermal dissipating elements 120, such as pin fins 125. Manifold 640 includes a first sidewall 661 and a second sidewall 663 connected together by a ceiling 662. This configuration forms a substantially U-shaped body that defines a central cavity 660 within the manifold 640 and encases IC die 105 when the manifold 640 is placed or mounted to the PCB 106. The manifold 640 may be joined to the PCB 106 using various means, and in this example, an adhesive 652 joins a top surface of PCB 106 to and the first and second sidewalls 661, 663. The adhesive material 652 provides a sealing interface between the manifold 640 and the PCB 106.

A sealing member may be utilized to seal the interface where the manifold 640 contacts the IC die 105. In some examples, sealing member 665 may be an adhesive material, an O ring, or suitable mechanical attachments that facilitate positioning and securement of the manifold 640 to the IC die 105. A plenum 621 may be defined by the ceiling 662 of the manifold 640.

Once the manifold 640 is positioned on the PCB 106 with the plurality of thermal dissipating elements 120 disposed on the IC die 105, the installation of the manifold 640 is then considered completed and liquid cooling can take place. As shown in FIG. 6C, the plenum 621 may allow a cooling medium, including cooling fluid, air, liquid, or other such cooling material to be introduced therein for temperature control purposes to the IC die 105. Such cooling materials may enter the plenum through inlet 627 of the plenum 621, around thermal control elements 120, and exit the plenum through outlet 628.

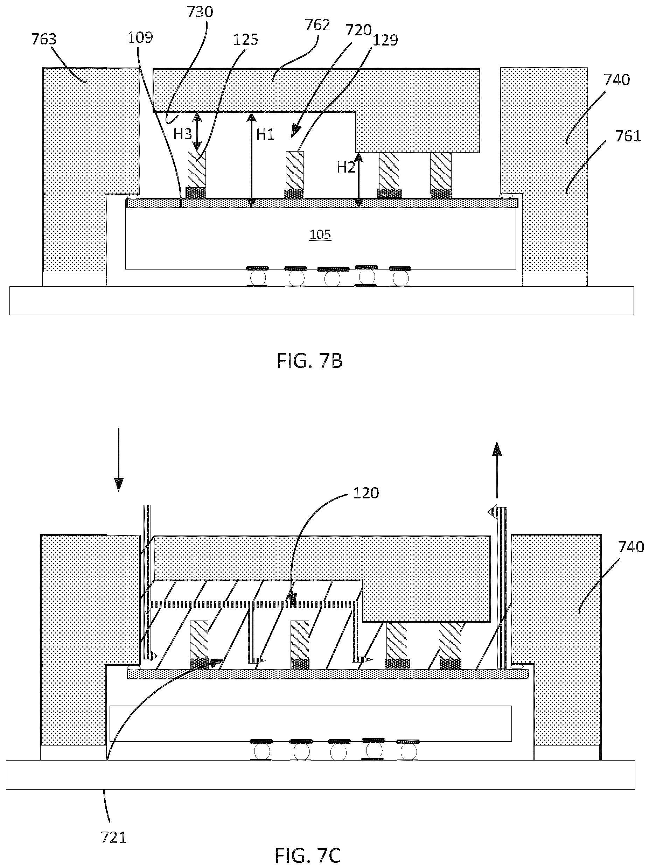

Another example manifold 740 that may be implemented in connection with a same or different arrangement of thermal conductive components 120 is discussed in FIGS. 7A-7C. For example, after reflow of the in-process thermal assembly 510 described in FIG. 5E, instead of proceeding with the manufacturing process shown in FIG. 5F, the remaining components of the pin fin placement assembly 500 can alternatively be removed altogether. As shown in FIG. 7A, removal of the remaining components of the pin fin assembly results in a structure that includes PCB 106, IC die 105, and thermally conductive elements 120, including pin fins 125 that are joined to IC die 105 by solder connections 124. In FIG. 7B, manifold 740 may include a first sidewall 761 and a second sidewall 763 connected together by a ceiling 762. As shown, the bottom surface 730 of ceiling 762 has two different heights H1 and H2 away from the rear surface 109 of IC die 105, as well as a height H3 away from some of the thermally conductive elements 120, and in this example, top surfaces 129 of some of the pin fins 125. As shown in FIG. 7C, the variation in height allows for a variation in the cooling material through the plenum 721 of the manifold 740, as well as more control over the distribution of cooling material through the plenum 721 and around the thermally conductive elements 120.

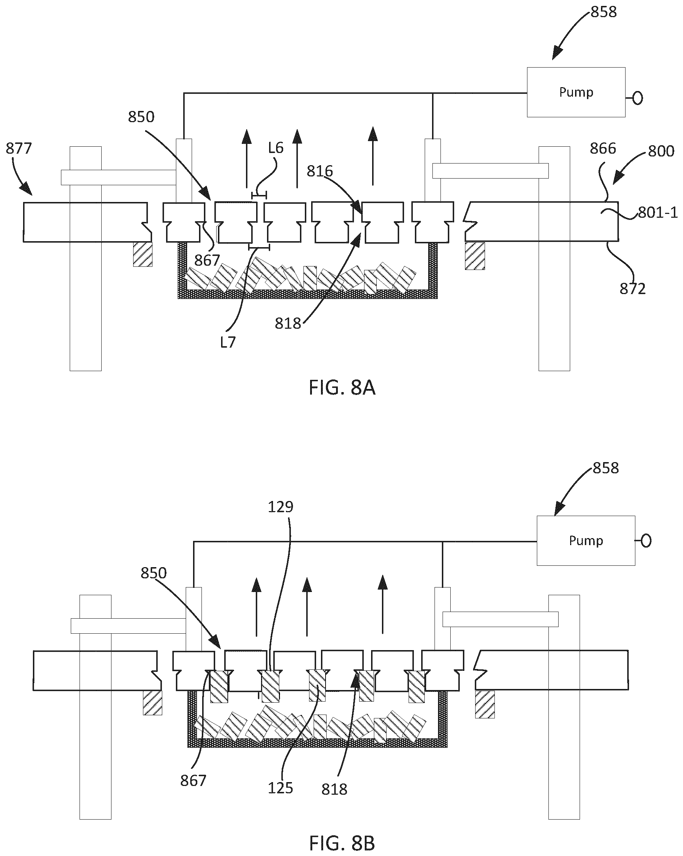

It is to be appreciated that although the prior embodiments illustrate use of a multi-plate system within the pin-fin assembly, a single plate can also be implemented. For example, FIGS. 8A-8D illustrate another example pin fin assembly 800 that includes a vacuum pickup assembly 858. This example differs from the previous examples in that instead of the plate body 877 having an upper plate, middle plate, and/or bottom plate, the plate body 877 is a single plate 801-1. Plate 801-1 includes a top surface 866, a bottom surface 872, and apertures 850 that extend through the top surface 866 and bottom surface 872. Apertures 850 extend through the top and bottom surfaces 866 and 872 and have a configuration in which each of the apertures 850 includes an upper portion 816 that has a diameter or length L6 that is smaller than a diameter or length L7 of the lower portion 818. An edge surface 867 is formed at the transition in the diameters between the upper portion 816 and lower portion 818. Edge surface 867 is just one example of the transition between the upper portion 816 and lower portion 818, but other shapes and types of surfaces may be implemented to create a surface against which a thermal dissipating element, such as pin fin 125, can be held.

As shown in FIG. 8B, apertures 850 may be configured to receive pin fins 125 in the lower portion 818 of apertures 850. Vacuum pickup suction from the vacuum pickup assembly 858 will pull pin fins 125 from a receptacle 823 into the apertures 850, and in this example the lower portions 818 of the apertures 850. The top surfaces 129 of the pin fins 125 will be held in place against the edge surfaces 867. In other examples, various cut out shapes within the apertures 850 or other edge surfaces can be created to provide a surface against which top surfaces 129 of pin fins 125 may be adjacent to and/or which will prevent pin fins 125 from moving to the upper portions 816 of the apertures 850.

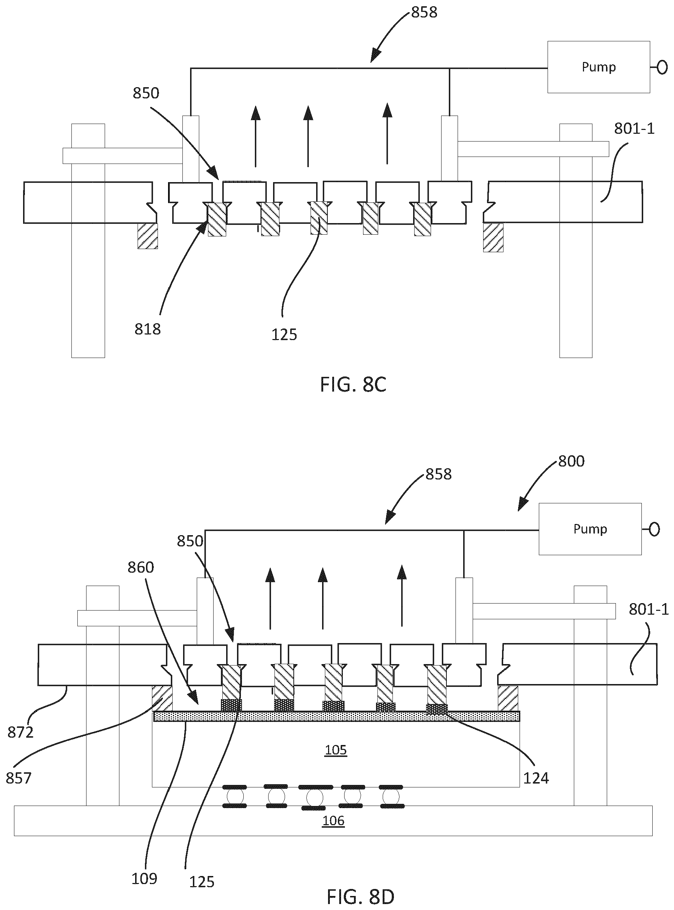

Once the pin fins 125 are in place, the pin fin receptacle 853 may be removed, as shown in FIG. 8C. Vacuum suction from the vacuum pickup assembly 858 may continue to secure the pin fins 125 within the lower portion 818 of apertures 850 of plate 801-1, while further processing takes place.

With the pin fin receptacle 853 removed, the pin fins 125 may be joined to another microelectronic device or assembly. In one example, pin fins 125 may be coupled to IC die 105 and PCB 106, as shown in FIG. 8D and previously described herein. As in previous examples, pin fins 125 may be aligned with solder connections 124, as the IC die 105 and PCB 106 are coupled to plate 801-1 of the pin fin placement assembly 800. While the solder connections 124 are in the process of being aligned with the pin fins 125, the vacuum pickup assembly 858 will remain active and secure the pin fins 125 within the apertures 850. The cooling chamber supports 857 may also be coupled to the rear surface 109 of the IC die 105. This creates an enclosed interior cavity 860 between the bottom surface 872 of plate 801-1 and the rear surface 109 of IC die 105.

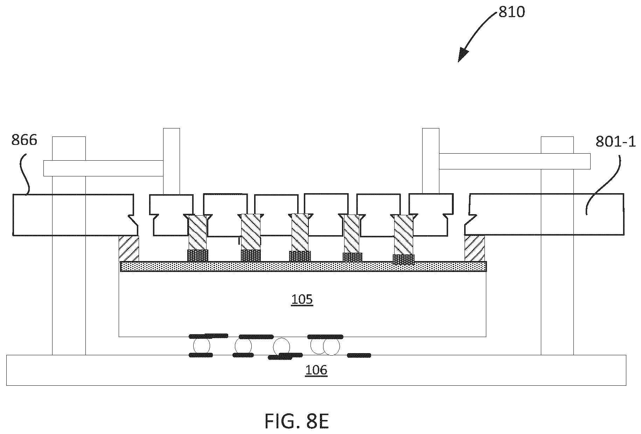

Once pin fins 125 are aligned with solder connections 124, the vacuum pickup assembly 858 may be removed. As shown in FIG. 8E, removal of the vacuum pickup assembly 858 results in an in-process thermal assembly 800A and further thermal processing can take place. As previously discussed, a manifold (not shown) can be provided on the top surface 866 of plate 801-1 of the pin fin placement assembly 800 or alternatively, the plate 801-1 can be removed altogether and a manifold can be coupled to the IC die 105 and PCB 106 without use of the pin fin placement assembly 800.

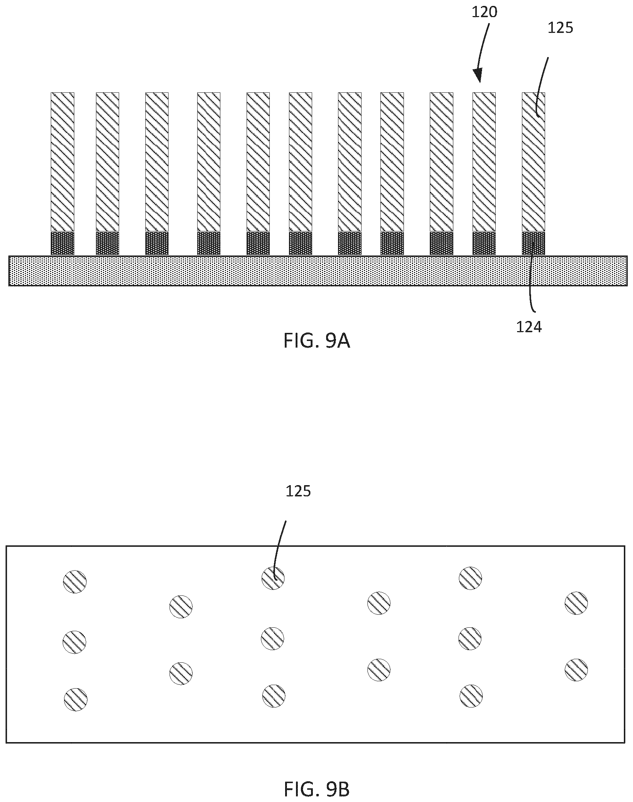

FIG. 9A depicts a cross-sectional view of the plurality of thermal dissipating elements 120 and FIG. 9B depicts a top view of the thermal dissipating elements 120 of FIG. 9A. As described above, the thermal dissipating element 120 includes the plurality of pin fins 125 disposed on the solder connections 124. The thermal dissipating element 120 may be configured as arrays or matrix that includes multiple thermal dissipating elements 120 equally or non-equally spaced apart from each other. As depicted in the top view of the thermal dissipating element 120 in FIG. 9B, the thermal dissipating element 120 may be configured in a circular configuration to facilitate thermal dissipation. In one example, the thermal dissipating element 120 may have a diameter between about 20 µm and about 80 µm. In other examples, the diameter may be less than 80 µm and greater than 20 µm.

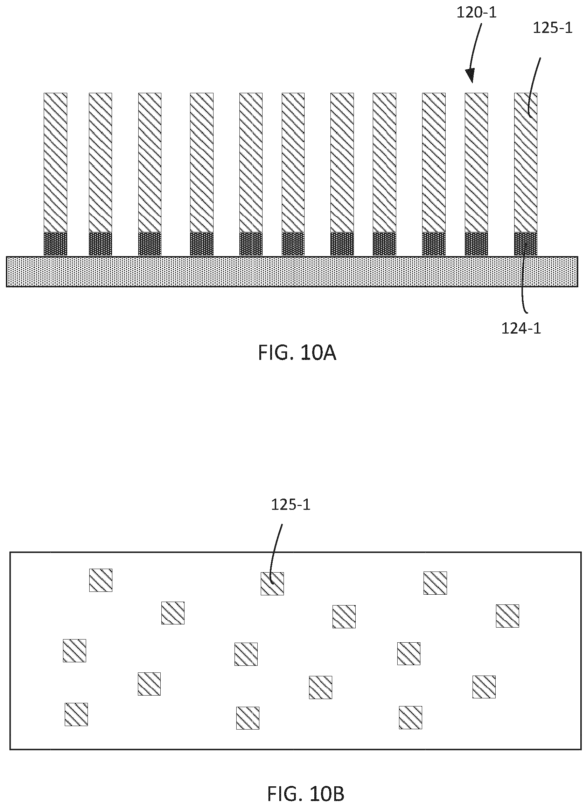

In another example, depicted in FIGS. 10A-10B, the thermal dissipating element 120-1 includes the plurality of pin fins 125-1 disposed on solder connections 124,-1 as shown in the cross-sectional view of FIG. 10A. The thermal dissipating elements 120-1 may be configured as arrays or matrix that includes multiple thermal dissipating elements 120-1 equally or non-equally spaced apart from each other. The thermal dissipating element 120-1 may be configured to have a rectangular configuration, as shown in the top view in FIG. 10B. The thermal dissipating element 120-1 may be a longitudinal structure. For example, the thermal dissipating element 120-1 may have a dimension between about 20 µm and about 80 µm.

Based on different configurations, densities, distributions, and profiles of the pin fins disclosed herein, the apertures formed in any one of the previously disclosed plates may be changed or altered accordingly to accommodate different configurations, densities, distributions, and profiles of the pin fins.

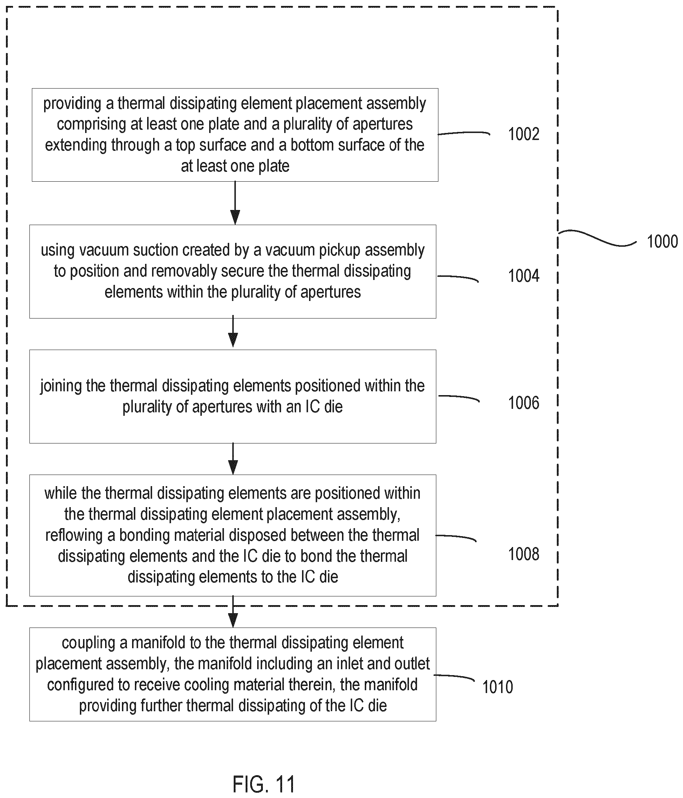

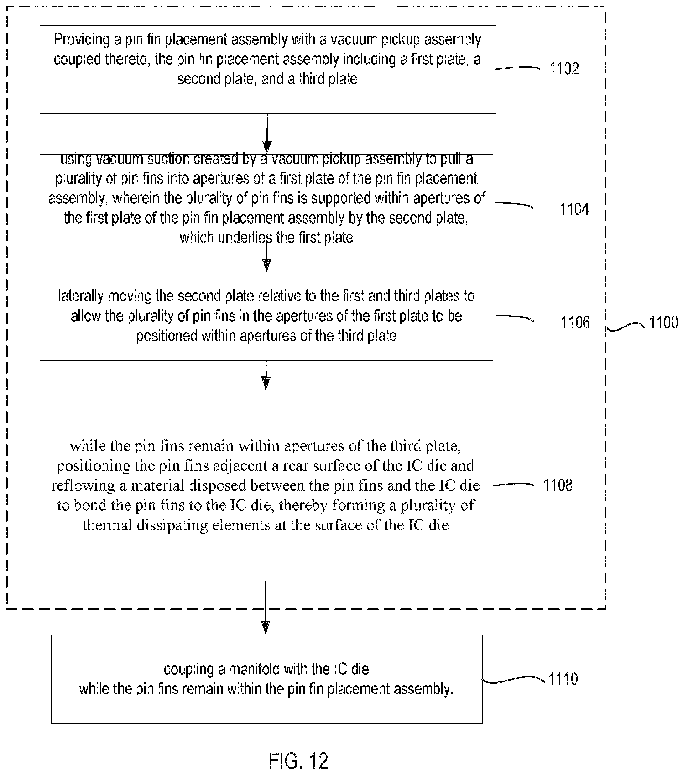

FIGS. 11-12 depict example flow diagrams for manufacturing an IC package that includes an IC die having thermal dissipating elements to control the temperature of the IC die in accordance with aspects of the disclosure. It should be understood that the operations involved in the following methods need not be performed in the precise order described. Rather, various operations may be handled in a different order or simultaneously, and operations may be added or omitted.

Referring to FIG. 11, blocks 1002 through 1008 of the flow diagram illustrate an example 1000 for bonding thermal dissipating elements to an IC die.

In block 1002, a thermal dissipating element placement assembly is provided that comprises at least one plate and a plurality of apertures extending through a top surface and a bottom surface of the at least one plate. The thermal dissipating element placement assembly can comprise a single plate or multi-plate structure with apertures therein for receiving pin fins.

In block 1004, vacuum suction created by a vacuum pickup assembly may be used to position and removably secure the thermal dissipating elements within the plurality of apertures.

In block 1006, the thermal dissipating elements positioned within the plurality of apertures may be joined with an IC die.

In block 1008, while the thermal dissipating elements are positioned within the thermal dissipating element placement assembly, a bonding material disposed between the thermal dissipating elements and the IC die to bond the thermal dissipating elements to the IC die may be reflowed. In some examples, a solder connection between the IC die and the plurality of pin fins may be formed.

Block 1010 illustrates an optional block, in which a manifold may be coupled to the thermal dissipating element placement assembly. The manifold may include an inlet and an outlet configured to receive cooling material therein, the manifold providing further thermal dissipation of the IC die.

Referring to FIG. 11, blocks 1102 through 1108 of the flow diagram illustrate another example 1100 for bonding thermal dissipating elements to an IC die. At block 1102, a pin fin placement assembly with a vacuum pickup assembly coupled thereto is provided. The pin fin placement assembly comprises a first plate, a second plate, and a third plate.

At block 1104, vacuum suction created by a vacuum pickup assembly is used to pull a plurality of pin fins into apertures of a first plate of the pin fin placement assembly. The plurality of pin fins may be supported within apertures of the first plate of the pin fin placement assembly by the second plate, which underlies the first plate.

At block 1106, the second plate is laterally moved laterally moved relative to the first and third plates to allow the plurality of pin fins in the apertures of the first plate to be positioned within apertures of the third plate.

At block 1108, while the pin fins remain within apertures of the third plate, the pin fins may be positioned adjacent a rear surface of the IC die and a material disposed between the pin fins and the IC die may be reflowed to bond the pin fins to the IC die, thereby forming a plurality of thermal dissipating elements at the surface of the IC die.

At block 1110, while the pin fins remain within the pin fin placement assembly, reflowing a material disposed between the pin fins and the IC die to bond the pin fins to the IC die, thereby forming a plurality of pin fins or thermal dissipating elements at the surface of the IC die.

Block 1112 illustrates an optional block, in which a manifold may be coupled to the IC die while the pin fins remain within the pin fin placement assembly.

The features described herein provide improved methods and structures for formation of thermal dissipation elements on the rear surface of an IC die using an improved thermal dissipation element placement assembly with a vacuum pickup assembly, as well as providing methods and structures for the optional addition of a thermal cooling structure, such as a manifold alone or in combination with the thermal dissipation element placement assembly. Both methods and structures may provide high heat dissipation efficiency to an IC die during operation assembled in the package assembly. The pin fins attached to the rear surface of the IC die, alone or in combination with a manifold encasing the IC die may assist in temperature control of the IC die when in operation. In one example, a plurality of thermal dissipating elements may be disposed on a first surface of the IC die encased under a manifold to efficiently control and dissipate the thermal energy from the IC die when in operation. A second surface opposite to the first surface of the IC die may include a plurality of devices, such as semiconductors transistors, devices, electrical components, circuits, or the like, that may generate thermal energy when in operation. The thermal dissipating elements may be manufactured by utilizing the thermal dissipation element placement assembly to position thermal dissipation elements efficiently and precisely, such as pin fins on desired locations of the IC die. Different configurations of the thermal dissipating elements may be utilized to accommodate different device layouts with different thermal energy generation across the substrate in the IC die. Thus, an IC die package can be provided with high efficiency of heat dissipation that is suitable for 3D IC package structures and requirements.

According to an aspect of the disclosure, an assembly for positioning a plurality of thermal dissipating elements on an integrated circuit ("IC") die comprises a thermal dissipating element placement assembly and a vacuum pickup assembly. The thermal dissipating element further comprises a plate body having a first plate and a second plate. The first plate has a first plurality of apertures extending through top and bottom surfaces of the first plate. The second plate may also have a second plurality of apertures extending through top and bottom surfaces of the second plate. Each of the second plurality of apertures may have a diameter that is different than a diameter of each of the first plurality of apertures. The second plurality of apertures may be aligned with the first plurality of apertures. The vacuum pickup assembly may be removably coupled to the thermal dissipating element placement assembly. The vacuum pickup assembly may provide a suction force that holds the plurality of thermal dissipating elements within the first or second plurality of apertures in the plate body and against a surface of the plate body; and/or
the vacuum pickup assembly overlies the IC die and holds the thermal dissipating elements within the first or second plurality of apertures. Each of the first or second plurality of apertures of the thermal dissipating element placement assembly may be aligned with conductive connections disposed at the IC die; and/or
the first plate overlies the second plate, and the first diameter of the first plurality of apertures is smaller than the second diameter of the second plurality of apertures, such that a force created by the vacuum pickup assembly holds the plurality of thermal dissipating elements within the second plurality of apertures and against a bottom surface of the first plate; and/or
the bottom surface of the first plate is configured to contact top surfaces of the plurality of thermal dissipating elements. The bottom surface of the first plate prevents the plurality of thermal dissipating elements from being pulled into the first plurality of apertures; and/or
the first plate overlies the second plate and the first diameter of the first plurality of apertures is smaller than the second diameter of the second plurality of apertures, and the first and second plurality of apertures is aligned and bottom surfaces of the first plate overlie at least portions of the second plurality of apertures. The bottom surface of the first plate may be configured to contact top surfaces of the plurality of thermal dissipating elements in the second plurality of apertures and to prevent the thermal dissipating elements from moving to the first plurality of apertures; and/or
the vacuum pickup assembly further comprises a vacuum pickup pump and a vacuum chamber; and/or
the first plate overlies the second plate, and the vacuum chamber is coupled to the second plate; and/or
the thermal dissipating elements are elongated pin fins.

According to another aspect of the disclosure, an assembly for positioning thermal dissipating elements on an integrated circuit ("IC") die comprises a thermal dissipating element placement assembly and a vacuum pickup assembly. The thermal dissipating element placement assembly may comprise a top plate, a middle plate, and a lower plate vertically assembled to form a plate body. The middle plate may be movable relative to the top plate and/or the lower plate. A first plurality of apertures may be formed in the top plate; and a second plurality of apertures may be formed in the lower plate. The first and the second plurality of apertures are vertically aligned. The first and the second plurality of apertures may be configured to receive the thermal dissipating elements therein. The thermal dissipating elements may be configured to be disposed on an IC die. The vacuum pickup assembly may be removably coupled to the thermal dissipating element placement assembly. The vacuum pickup assembly may be configured to hold the thermal dissipating elements against at least a portion of the plate body; and/or
the vacuum pickup assembly further comprises a vacuum pickup pump and a vacuum chamber positioned adjacent the lower plate; and/or
the middle plate may be positioned between the top plate and the lower plate and the middle plate may be laterally movable relative to the top plate and/or lower plate from a first thermal dissipating element support position to a second thermal dissipating element release position. When in the first thermal dissipating element support position, the middle plate is configured to support the thermal dissipating elements within the first plurality of apertures; and/or
the middle plate further comprises a third plurality of apertures formed in the middle plate. The third plurality of apertures may be vertically aligned with the first and second plurality of apertures when the middle plate is in the first thermal dissipating element support position. When the middle plate is in the thermal dissipating element release position, the third plurality of apertures do not vertically align with the first and second plurality of apertures. A diameter of the third plurality of apertures may be smaller than a diameter of the first plurality of apertures; and/or
the assembly further comprises a plurality of supports coupled to the plate body; and/or
the thermal dissipating elements are elongated pin fins; and/or
the middle plate further comprises a fourth plurality of apertures that has a diameter that is substantially the same as the diameter of the first plurality of apertures; and/or

According to another aspect of the disclosure, an assembly comprises an integrated circuit ("IC"), a thermal dissipating element placement assembly, a plurality of thermal dissipating elements and a manifold. The IC die may be electrically connected to a printed circuit board ("PCB"). The thermal dissipating element placement assembly may be coupled to the PCB. The thermal dissipating element placement assembly may comprise a plate body having a top surface, a bottom surface, and a plurality of apertures extending through the top and bottom surfaces. The plurality of thermal dissipating elements may be disposed within the plurality of apertures and coupled to a surface of the IC die. The manifold may be coupled to the plate body and the IC die, the manifold configured to provide thermal dissipating of the IC die; and/or
the thermal dissipating element placement assembly further comprises cooling chamber supports extending from the thermal dissipating element placement assembly; and/or
the thermal dissipating elements extend between the thermal dissipating element placement assembly and the IC die; and/or
the manifold is coupled to a rear surface of the plate body and overlies the IC die; and/or
the thermal dissipating elements are pin fin elements, and a top portion of the pin fin elements are positioned within the apertures of the plate body and a bottom portion of the pin fin elements are bonded to the IC die.

According to another aspect of the disclosure, a method for providing thermal dissipating elements on an integrated circuit ("IC") die, comprises providing a thermal dissipating element placement assembly comprising at least one plate and a plurality of apertures extending through a top surface and a bottom surface of the at least one plate; using vacuum suction created by a vacuum pickup assembly to position and removably secure the thermal dissipating elements within the plurality of apertures; and joining the thermal dissipating elements positioned within the plurality of apertures with an IC die. While the thermal dissipating elements are positioned within the thermal dissipating element placement assembly, a bonding material disposed between the thermal dissipating elements and the IC die may be reflowed to bond the thermal dissipating elements to the IC die; and/or
coupling a manifold to the thermal dissipating element placement assembly. The manifold includes an inlet and an outlet configured to receive cooling material therein, and the manifold may provide further thermal dissipation of the IC die; and/or
removing the thermal dissipating element placement assembly and coupling a manifold to the IC die. The manifold may comprise a plenum for receiving cooling materials therein; and/or
supplying a cooling fluid into the plenum to regulate a thermal energy transmitted from the IC die; and/or
the thermal dissipating element placement assembly comprises a single plate. The plurality of apertures each has a diameter that decreases in size between the top surface and the bottom surface; and/or
the at least one plate is a first plate and the plurality of apertures is a first plurality of apertures. The thermal dissipating element placement assembly may further comprise a second plate having a second plurality of apertures aligned with the first plurality of apertures. The first plurality of apertures of the first plate may be smaller than the second plurality of apertures; and/or
the first plate overlies the second plate. The suction force created by the vacuum pickup assembly holds the thermal dissipating elements against the bottom surface of the first plate; and/or
using the vacuum pickup assembly to draw the thermal dissipating elements into the plurality of apertures and secure the thermal dissipating elements within the plurality of apertures; and/or
the at least one plate is a first plate and the plurality of apertures is a first plurality of apertures. The thermal dissipating element placement assembly further comprises a second plate positioned below the first plate and having a second plurality of apertures aligned with the first plurality of apertures. The first plurality of apertures may be smaller than the second plurality of apertures. The vacuum pickup assembly draws the thermal dissipating elements into the second plurality of apertures; and/or
the at least one plate is a first plate and the plurality of apertures is a first plurality of apertures, wherein the thermal dissipating element placement assembly further comprises a second plate positioned below the first plate and having a second plurality of apertures aligned with the first plurality of apertures, wherein the first plurality of apertures is larger than the second plurality of apertures, and wherein the vacuum pickup assembly draws the thermal dissipating elements into the first plurality of apertures; and/or
the thermal dissipating elements are elongated pin fins, and the method further comprises arranging the pin fins in one or more arrays or matrices.

According to another aspect of the disclosure, a method for providing thermal dissipating elements on an integrated circuit ("IC") die comprises providing a pin fin placement assembly with a vacuum pickup assembly coupled thereto; using vacuum suction created by a vacuum pickup assembly to pull a plurality of pin fins into apertures of a first plate of the pin fin placement assembly; and laterally moving the second plate relative to the first and third plates to allow the plurality of pin fins in the apertures of the first plate to be positioned within apertures of the third plate. The pin fin placement assembly includes a first plate, a second plate, and a third plate. The plurality of pin fins may be supported within apertures of the first plate of the pin fin placement assembly by the second plate, which underlies the first plate. While the pin fins remain within apertures of the third plate, the pin fins may be positioned adjacent a rear surface of the IC die. A material disposed between the pin fins and the IC die may be reflowed to bond the pin fins to the IC die, thereby forming a plurality of thermal dissipating elements at the surface of the IC die; and/or
removing the pin fin placement assembly and coupling a manifold with the IC die and a PCB to encase the IC die; and/or
coupling a manifold with the IC die while the pin fins remain within the pin fin placement assembly; and/or
while the pin fins remain within the pin fin placement assembly, a portion of the pin fins are positioned within the apertures of the third plate and a portion of the pin fins are exposed.

## Claims

1. An assembly for positioning a plurality of thermal dissipating elements (120) on an integrated circuit, IC, die (105) comprising:
a thermal dissipating element placement assembly comprising:
a plate body (577) comprising a first plate (501) and a second plate (503), the first plate (501) having a first plurality of apertures (550) extending through top and bottom surfaces of the first plate (501) and the second plate (503) having a second plurality of apertures (552) extending through top and bottom surfaces of the second plate (503), each of the second plurality of apertures (552) having a second diameter that is different than a first diameter of each of the first plurality of apertures (550), the second plurality of apertures (552) being aligned with the first plurality of apertures (550), and
a vacuum pickup assembly (558) removably coupled to the thermal dissipating element placement assembly, the vacuum pickup assembly (558) providing a suction force that holds the plurality of thermal dissipating elements (120) within the first (550) or second plurality of apertures (552) in the plate body (577) and against a surface of the plate body (577).

2. The assembly of claim 1, wherein the vacuum pickup assembly (558) overlies the IC die (105) and holds the thermal dissipating elements (120) within the first (550) or second plurality of apertures (552), each of the first (550) or second plurality of apertures (552) of the thermal dissipating element placement assembly (558) being aligned with conductive connections (124) disposed at the IC die (105); or
wherein the first plate (501) overlies the second plate (503), and the first diameter of the first plurality of apertures (550) is smaller than the second diameter of the second plurality of apertures (552), such that a force created by the vacuum pickup assembly (558) holds the plurality of thermal dissipating elements (120) within the second plurality of apertures (552) and against a bottom surface of the first plate (501); or
wherein the bottom surface of the first plate (501) is configured to contact top surfaces of the plurality of thermal dissipating elements (120), the bottom surface of the first plate (501) preventing the plurality of thermal dissipating elements (120) from being pulled into the first plurality of apertures (550).

3. The assembly of claim 2, wherein the first plate (501) overlies the second plate (503) and the first diameter of the first plurality of apertures (550) is smaller than the second diameter of the second plurality of apertures (552), wherein the first (550) and second plurality of apertures (552) are aligned and bottom surfaces of the first plate (501) overlie at least portions of the second plurality of apertures (552), the bottom surface of the first plate (501) being configured to contact top surfaces of the plurality of thermal dissipating elements (120) in the second plurality of apertures (552) and to prevent the thermal dissipating elements (120) from moving to the first plurality of apertures (550).

4. The assembly of one of claims 1 to 3, wherein the vacuum pickup assembly (558) further comprises a vacuum pickup pump (559) and a vacuum chamber (562); and
wherein the first plate (501) optionally overlies the second plate (503), and the vacuum chamber (562) is coupled to the second plate (503).

5. An assembly for positioning thermal dissipating elements (120) on an integrated circuit, IC, die comprising:
a thermal dissipating element placement assembly (200) comprising:
a top plate (201), a middle plate (202), and a lower plate (203) vertically assembled to form a plate body (277), wherein the middle plate (202) is movable relative to the top plate (201) and/or the lower plate;
a first plurality of apertures (250) formed in the top plate (201); and
a second plurality of apertures (252) formed in the lower plate, wherein the first (250) and the second plurality of apertures (252) are vertically aligned, wherein the first (250) and the second plurality of apertures (252) are configured to receive the thermal dissipating elements (120) therein, the thermal dissipating elements (120) configured to be disposed on an IC die (105), and
a vacuum pickup assembly (258) removably coupled to the thermal dissipating element placement assembly (200), the vacuum pickup assembly (258) configured to hold the thermal dissipating elements (120) against at least a portion of the plate body (277).

6. The assembly of claim 5, wherein the vacuum pickup assembly (258) further comprises a vacuum pickup pump (259) and a vacuum chamber (262) positioned adjacent the lower plate (203); or
wherein the middle plate (202) is positioned between the top plate (201) and the lower plate (203), the middle plate (202) being laterally movable relative to the top plate (201) and/or lower plate (203) from a first thermal dissipating element support position to a second thermal dissipating element release position, wherein in the first thermal dissipating element support position, the middle plate (202) is configured to support the thermal dissipating elements (120) within the first plurality of apertures (250).

7. The assembly of claim 6, wherein the middle plate (202) further comprises a third plurality of apertures (254) formed in the middle plate (202), the third plurality of apertures (254) being vertically aligned with the first (250) and second plurality of apertures (252) when the middle plate (202) is in the first thermal dissipating element support position, and wherein when the middle plate (202) is in the thermal dissipating element release position, the third plurality of apertures (254) do not vertically align with the first (250) and second plurality of apertures (252), a diameter of the third plurality of apertures (254) being smaller than a diameter of the first plurality of apertures (250).

8. An assembly, comprising:
an integrated circuit, IC, die (105) electrically connected to a printed circuit board, PCB (106);
a thermal dissipating element placement assembly (800) coupled to the PCB (106), the thermal dissipating element placement assembly (800) comprising a plate body (877) having a top surface (866), a bottom surface (872), and a plurality of apertures (850) extending through the top (866) and bottom surfaces (872), wherein the plurality of apertures (850) each has a diameter that decreases in size between the bottom surface (872) and the top surface (866);
a plurality of thermal dissipating elements (120) disposed within the plurality of apertures (850) and coupled to a surface of the IC die (105); and
a manifold coupled to the plate body (877) and the IC die (105), the manifold configured to provide thermal dissipating of the IC die (105).

9. The assembly of claim 8, wherein the thermal dissipating element placement assembly (800) further comprises cooling chamber supports (857) extending from the thermal dissipating element placement assembly (800); and
wherein thermal dissipating elements (120) optionally extend between the thermal dissipating element placement assembly (800) and the IC die (105); or
wherein the manifold optionally is coupled to a rear surface of the plate body and overlies the IC die (105); or
wherein the thermal dissipating elements optionally are pin fin elements (125), and a top portion of the pin fin elements are positioned within the apertures (850) of the plate body (877) and a bottom portion of the pin fin elements are bonded to the IC die (105).

10. A method for providing thermal dissipating elements (120) on an integrated circuit, IC, die (105), comprising:
providing (1002) a thermal dissipating element placement assembly comprising at least one plate and a plurality of apertures (250) extending through a top surface and a bottom surface of the at least one plate;
using (1004) vacuum suction created by a vacuum pickup assembly (258) to position and removably secure the thermal dissipating elements (120) within the plurality of apertures (250);
joining (1006) the thermal dissipating elements (120) positioned within the plurality of apertures (250) with an IC die (105); and
while the thermal dissipating elements (120) are positioned within the thermal dissipating element placement assembly, reflowing (1008) a bonding material disposed between the thermal dissipating elements (120) and the IC die (105) to bond the thermal dissipating elements (120) to the IC die (105); or
further comprising coupling (1010) a manifold (140) to the thermal dissipating element placement assembly, the manifold (140) including an inlet (127) and an outlet (128) configured to receive cooling material therein, the manifold (140) providing further thermal dissipation of the IC die (105); or
further comprising removing the thermal dissipating element placement assembly and coupling a manifold (140) to the IC die (105), the manifold (140) comprising a plenum for receiving cooling materials therein; and/or
further comprising optionally supplying a cooling fluid into the plenum to regulate a thermal energy transmitted from the IC die (105).

11. The method of claim 10, wherein the thermal dissipating element placement assembly comprises a single plate, and wherein the plurality of apertures (250) each has a diameter that decreases in size between the top surface and the bottom surface; or
wherein the at least one plate is a first plate (201) and the plurality of apertures (250) is a first plurality of apertures (250), wherein the thermal dissipating element placement assembly further comprises a second plate having a second plurality of apertures (250) aligned with the first plurality of apertures (250), wherein the first plurality of apertures (250) of the first plate are smaller than the second plurality of apertures (250).

12. The method of claim 11, wherein the first plate overlies the second plate, and wherein the suction force created by the vacuum pickup assembly (258) holds the thermal dissipating elements (120) against the bottom surface of the first plate.

13. The method of one of claims 10 to 12, wherein the at least one plate is a first plate and the plurality of apertures (250) is a first plurality of apertures (250), wherein the thermal dissipating element placement assembly further comprises a second plate positioned below the first plate and having a second plurality of apertures (250) aligned with the first plurality of apertures (250), wherein the first plurality of apertures (250) are smaller than the second plurality of apertures (250), and wherein the vacuum pickup assembly (258) draws the thermal dissipating elements (120) into the second plurality of apertures (250); or
wherein the at least one plate is a first plate and the plurality of apertures (250) is a first plurality of apertures (250), wherein the thermal dissipating element placement assembly further comprises a second plate positioned below the first plate and having a second plurality of apertures (250) aligned with the first plurality of apertures (250), wherein the first plurality of apertures (250) is larger than the second plurality of apertures (250), and wherein the vacuum pickup assembly (258) draws the thermal dissipating elements (120) into the first plurality of apertures (250).

14. A method for providing thermal dissipating elements (120) on an integrated circuit, IC, die (105), comprising:
providing (1102) a pin fin placement assembly with a vacuum pickup assembly (258) coupled thereto, the pin fin placement assembly including a first plate (201), a second plate (202), and a third plate (203);
using (1104) vacuum suction created by a vacuum pickup assembly (258) to pull a plurality of pin fins (125) into apertures (250) of a first plate (201) of the pin fin placement assembly, wherein the plurality of pin fins (125) is supported within apertures (250) of the first plate of the pin fin placement assembly by the second plate (202), which underlies the first plate (201);
laterally moving (1106) the second plate (202) relative to the first (201) and third (203) plates to allow the plurality of pin fins (125) in the apertures (250) of the first plate (201) to be positioned within apertures (252) of the third plate (203);
while the pin fins (125) remain within apertures (250) of the third plate (203), positioning (1108) the pin fins (125) adjacent a rear surface of the IC die (105) and reflowing a material disposed between the pin fins (125) and the IC die (105) to bond the pin fins (125) to the IC die (105), thereby forming a plurality of thermal dissipating elements (120) at the surface of the IC die (105).

15. The method of claim 14, further comprising removing the pin fin placement assembly and coupling a manifold (140) with the IC die (105) and a printed circuit board to encase the IC die (105); or
further comprising coupling (1110) a manifold (140) with the IC die (105) while the pin fins (125) remain within the pin fin placement assembly; or
wherein while the pin fins (125) remain within the pin fin placement assembly, a portion of the pin fins (125) are positioned within the apertures (250) of the third plate (203) and a portion of the pin fins (125) are exposed.

## Patentansprüche

1. Baugruppe zum Positionieren einer Vielzahl von Wärmeableitungselementen (120) auf einem integrierten Schaltungschip, IC-Chip, (105), umfassend:
eine Baugruppe zur Platzierung von Wärmeableitungselementen, umfassend:
einen Plattenkörper (577), umfassend eine erste Platte (501) und eine zweite Platte (503), wobei die erste Platte (501) eine erste Vielzahl von Öffnungen (550) aufweist, die sich durch eine obere und untere Fläche der ersten Platte (501) erstreckt, und die zweite Platte (503) eine zweite Vielzahl von Öffnungen (552) aufweist, die sich durch eine obere und untere Fläche der zweiten Platte (503) erstreckt, wobei jede der zweiten Vielzahl von Öffnungen (552) einen zweiten Durchmesser aufweist, der sich von einem ersten Durchmesser jeder der ersten Vielzahl von Öffnungen (550) unterscheidet, wobei die zweite Vielzahl von Öffnungen (552) mit der ersten Vielzahl von Öffnungen (550) ausgerichtet ist, und
eine Vakuumaufnehmerbaugruppe (558), die entfernbar an die Baugruppe zur Platzierung von Wärmeableitungselementen gekoppelt ist, wobei die Vakuumaufnehmerbaugruppe (558) eine Saugkraft bereitstellt, die die Vielzahl von Wärmeableitungselementen (120) innerhalb der ersten (550) oder zweiten Vielzahl von Öffnungen (552) in dem Plattenkörper (577) und gegen eine Fläche des Plattenkörpers (577) hält.

2. Baugruppe nach Anspruch 1, wobei die Vakuumaufnehmerbaugruppe (558) den IC-Chip (105) überlagert und die Wärmeableitungselemente (120) innerhalb der ersten (550) oder zweiten Vielzahl von Öffnungen (552) hält, wobei jede der ersten (550) oder zweiten Vielzahl von Öffnungen (552) der Baugruppe zur Platzierung von Wärmeableitungselementen (558) mit an dem IC-Chip (105) angeordneten leitenden Anschlüssen (124) ausgerichtet ist; oder
wobei die erste Platte (501) die zweiten Platte (503) überlagert und der erste Durchmesser der ersten Vielzahl von Öffnungen (550) kleiner ist als der zweite Durchmesser der zweiten Vielzahl von Öffnungen (552), sodass eine durch die Vakuumaufnehmerbaugruppe (558) erzeugte Kraft die Vielzahl von Wärmeableitungselementen (120) innerhalb der zweiten Vielzahl von Öffnungen (552) und gegen eine untere Fläche der ersten Platte (501) hält; oder
wobei die untere Fläche der ersten Platte (501) zum Kontaktieren der oberen Flächen der Vielzahl von Wärmeableitungselementen (120) konfiguriert ist, wobei die untere Fläche der ersten Platte (501) verhindert, dass die Vielzahl von Wärmeableitungselementen (120) in die erste Vielzahl von Öffnungen (550) gezogen wird.

3. Baugruppe nach Anspruch 2, wobei die erste Platte (501) die zweite Platte (503) überlagert und der erste Durchmesser der ersten Vielzahl von Öffnungen (550) kleiner ist als der zweite Durchmesser der zweiten Vielzahl von Öffnungen (552), wobei die erste (550) und zweite Vielzahl von Öffnungen (552) ausgerichtet sind und eine untere Fläche der ersten Platte (501) mindestens Abschnitte der zweiten Vielzahl von Öffnungen (552) überlagert, wobei die untere Fläche der ersten Platte (501) zum Kontaktieren oberer Flächen der Vielzahl von Wärmeableitungselementen (120) in der zweiten Vielzahl von Öffnungen (552) und zum Verhindern konfiguriert ist, dass sich die Wärmeableitungselemente (120) zu der ersten Vielzahl von Öffnungen (550) bewegen.

4. Baugruppe nach einem der Ansprüche 1 bis 3, wobei die Vakuumaufnehmerbaugruppe (558) ferner eine Vakuumaufnehmerpumpe (559) und eine Vakuumkammer (562) umfasst; und
wobei die erste Platte (501) optional die zweite Platte (503) überlagert und die Vakuumkammer (562) an die zweite Platte (503) gekoppelt ist.

5. Baugruppe zum Positionieren von Wärmeableitungselementen (120) auf einem integrierten Schaltungschip, IC-Chip, umfassend:
eine Baugruppe zur Platzierung von Wärmeableitungselementen (200), umfassend:
eine obere Platte (201), eine mittlere Platte (202) und eine untere Platte (203), die vertikal unter Bilden eines Plattenkörpers (277) zusammengebaut sind, wobei die mittlere Platte (202) relativ zu der oberen Platte (201) und/oder der unteren Platte beweglich ist;
eine erste Vielzahl von Öffnungen (250), die in der oberen Platte (201) gebildet ist; und
eine zweite Vielzahl von Öffnungen (252), die in der unteren Platte gebildet ist, wobei die erste (250) und die zweite Vielzahl von Öffnungen (252) vertikal ausgerichtet sind, wobei die erste (250) und die zweite Vielzahl von Öffnungen (252) zum Aufnehmen der Wärmeableitungselemente (120) darin konfiguriert sind, wobei die Wärmeableitungselemente (120) zum Anordnen an einem IC-Chip (105) konfiguriert sind, und
eine Vakuumaufnehmerbaugruppe (258), die entfernbar an die Baugruppe zur Platzierung von Wärmeableitungselementen (200) gekoppelt ist, wobei die Vakuumaufnehmerbaugruppe (258) zum Halten der Wärmeableitungselemente (120) gegen mindestens einen Abschnitt des Plattenkörpers (277) konfiguriert ist.

6. Baugruppe nach Anspruch 5, wobei die Vakuumaufnehmerbaugruppe (258) ferner eine Vakuumaufnehmerpumpe (259) und eine Vakuumkammer (262) umfasst, die benachbart zu der unteren Platte (203) positioniert sind; oder
wobei die mittlere Platte (202) zwischen der oberen Platte (201) und der unteren Platte (203) positioniert ist, wobei die mittlere Platte (202) relativ zu der oberen Platte (201) und/oder unteren Platte (203) von einer ersten Position zum Halten von Wärmeableitungselementen zu einer zweiten Position zum Freigeben von Wärmeableitungselementen lateral beweglich ist, wobei die mittlere Platte (202) in der ersten Position zum Halten von Wärmeableitungselementen zum Halten der Wärmeableitungselemente (120) innerhalb der ersten Vielzahl von Öffnungen (250) konfiguriert ist.

7. Baugruppe nach Anspruch 6, wobei die mittlere Platte (202) ferner eine dritte Vielzahl von Öffnungen (254) umfasst, die in der mittleren Platte (202) gebildet sind, wobei die dritte Vielzahl von Öffnungen (254) vertikal mit der ersten (250) und zweiten Vielzahl von Öffnungen (252) ausgerichtet ist, wenn sich die mittlere Platte (202) in der ersten Position zum Halten von Wärmeableitungselementen befindet, und wobei die dritte Vielzahl von Öffnungen (254) nicht vertikal mit der ersten (250) und zweiten Vielzahl von Öffnungen (252) ausgerichtet ist, wenn sich die mittlere Platte (202) in der Position zum Freigeben von Wärmeableitungselementen befindet, wobei ein Durchmesser der dritten Vielzahl von Öffnungen (254) kleiner ist als ein Durchmesser der ersten Vielzahl von Öffnungen (250).

8. Baugruppe, umfassend:
einen integrierten Schaltungschip, IC-Chip, (105), der elektrisch mit einer Leiterplatte, PCB, (106) verbunden ist;
eine mit der PCB (106) gekoppelte Baugruppe zur Platzierung von Wärmeableitungselementen (800), wobei die Baugruppe zur Platzierung von Wärmeableitungselementen (800) einen Plattenkörper (877) umfasst, der eine obere Fläche (866), eine untere Fläche (872) und eine Vielzahl von Öffnungen (850) aufweist, die sich durch die obere Fläche (866) und die untere Fläche (872) erstreckt, wobei die Vielzahl von Öffnungen (850) jeweils einen Durchmesser aufweist, dessen Größe zwischen der unteren Fläche (872) und der oberen Fläche (866) abnimmt;
eine Vielzahl von Wärmeableitungselementen (120), die innerhalb der Vielzahl von Öffnungen (850) angeordnet und an eine Fläche des IC-Chips (105) gekoppelt sind; und
einen an den Plattenkörper (877) und den IC-Chip (105) gekoppelten Verteiler, wobei der Verteiler zum Bereitstellen von Wärmeableitung von dem IC-Chip (105) konfiguriert ist.

9. Baugruppe nach Anspruch 8, wobei die Baugruppe zur Platzierung von Wärmeableitungselementen (800) ferner Kühlkammerhalter (857) umfasst, die sich von der Baugruppe zur Platzierung von Wärmeableitungselementen (800) erstrecken; und wobei sich Wärmeableitungselemente (120) optional zwischen der Baugruppe zur Platzierung von Wärmeableitungselementen (800) und dem IC-Chip (105) erstrecken; oder
wobei der Verteiler optional an eine hintere Fläche des Plattenkörpers gekoppelt ist und den IC-Chip (105) überlagert; oder
wobei die Wärmeableitungselemente optional Nadelrippenelemente (125) sind und ein oberer Abschnitt der Nadelrippenelemente innerhalb der Öffnungen (850) des Plattenkörpers (877) positioniert ist und ein unterer Abschnitt der Nadelrippenelemente an den IC-Chip (105) gebondet ist.

10. Verfahren zum Bereitstellen von Wärmeableitungselementen (120) auf einem integrierten Schaltungschip, IC-Chip, (105), umfassend:
Bereitstellen (1002) einer Baugruppe zur Platzierung von Wärmeableitungselementen, umfassend mindestens eine Platte und eine Vielzahl von Öffnungen (250), die sich durch eine obere Fläche und eine untere Fläche der mindestens einen Platte erstreckt;
Verwenden (1004) von durch eine Vakuumaufnehmerbaugruppe (258) erzeugtem Vakuumsaugen zum Positionieren und entfernbaren Sichern der Wärmeableitungselemente (120) innerhalb der Vielzahl von Öffnungen (250);
Verbinden (1006) der innerhalb der Vielzahl von Öffnungen (250) positionierten Wärmeableitungselemente (120) mit einem IC-Chip (105); und
Aufschmelzen eines zwischen den Wärmeableitungselementen (120) und dem IC-Chip (105) angeordneten Bondmaterials (1008) zum Bonden der Wärmeableitungselemente (120) an den IC-Chip (105), während die Wärmeableitungselemente (120) innerhalb der Baugruppe zur Platzierung von Wärmeableitungselementen positioniert sind; oder
ferner umfassend Koppeln (1010) eines Verteilers (140) an die Baugruppe zur Platzierung von Wärmeableitungselementen, wobei der Verteiler (140) einen Einlass (127) und einen Auslass (128) beinhaltet und zum Aufnehmen von Kühlmaterial darin konfiguriert ist, wobei der Verteiler (140) weitere Wärmeableitung von dem IC-Chip (105) bereitstellt; oder
ferner umfassend Entfernen der Baugruppe zur Platzierung von Wärmeableitungselementen und Koppeln eines Verteilers (140) an den IC-Chip (105), wobei der Verteiler (140) ein Plenum zum Aufnehmen von Kühlmaterialien darin umfasst; und/oder
ferner umfassend optionales Zuführen eines Kühlfluids in das Plenum, um von dem IC-Chip (105) abgegebene thermische Energie zu regulieren.

11. Verfahren nach Anspruch 10, wobei die Baugruppe zur Platzierung von Wärmeableitungselementen eine einzelne Platte umfasst und wobei die Vielzahl von Öffnungen (250) jeweils einen Durchmesser aufweist, dessen Größe zwischen der oberen Fläche und der unteren Fläche abnimmt; oder
wobei die mindestens eine Platte eine erste Platte (201) ist und die Vielzahl von Öffnungen (250) eine erste Vielzahl von Öffnungen (250) ist, wobei die Baugruppe zur Platzierung von Wärmeableitungselementen ferner eine zweite Platte umfasst, die eine zweite Vielzahl von Öffnungen (250) aufweist, die mit der ersten Vielzahl von Öffnungen (250) ausgerichtet ist, wobei die erste Vielzahl von Öffnungen (250) der ersten Platte kleiner ist als die zweite Vielzahl von Öffnungen (250).

12. Verfahren nach Anspruch 11, wobei die erste Platte die zweite Platte überlagert und wobei die durch die Vakuumaufnehmerbaugruppe (258) erzeugte Saugkraft die Wärmeableitungselemente (120) gegen die untere Fläche der ersten Platte hält.

13. Verfahren nach einem der Ansprüche 10 bis 12, wobei die mindestens eine Platte eine erste Platte ist und die Vielzahl von Öffnungen (250) eine erste Vielzahl von Öffnungen (250) ist, wobei die Baugruppe zur Platzierung von Wärmeableitungselementen ferner eine zweite Platte umfasst, die unter der ersten Platte positioniert ist und eine zweite Vielzahl von Öffnungen (250) aufweist, die mit der ersten Vielzahl von Öffnungen (250) ausgerichtet ist, wobei die erste Vielzahl von Öffnungen (250) kleiner ist als die zweite Vielzahl von Öffnungen (250) und wobei die Vakuumaufnehmerbaugruppe (258) die Wärmeableitungselemente (120) in die zweite Vielzahl von Öffnungen (250) zieht; oder
wobei die mindestens eine Platte eine erste Platte ist und die Vielzahl von Öffnungen (250) eine erste Vielzahl von Öffnungen (250) ist, wobei die Baugruppe zur Platzierung von Wärmeableitungselementen ferner eine zweite Platte umfasst, die unter der ersten Platte positioniert ist und eine zweite Vielzahl von Öffnungen (250) aufweist, die mit der ersten Vielzahl von Öffnungen (250) ausgerichtet ist, wobei die erste Vielzahl von Öffnungen (250) größer ist als die zweite Vielzahl von Öffnungen (250) und wobei die Vakuumaufnehmerbaugruppe (258) die Wärmeableitungselemente (120) in die erste Vielzahl von Öffnungen (250) zieht.

14. Verfahren zum Bereitstellen von Wärmeableitungselementen (120) auf einem integrierten Schaltungschip, IC-Chip, (105), umfassend:
Bereitstellen (1102) einer Baugruppe zur Platzierung von Nadelrippen mit einer daran gekoppelten Vakuumaufnehmerbaugruppe (258), wobei die Baugruppe zur Platzierung von Nadelrippen eine erste Platte (201), eine zweite Platte (202) und eine dritte Platte (203) umfasst;
Verwenden (1104) von durch eine Vakuumaufnehmerbaugruppe (258) erzeugtem Vakuumsaugen zum Ziehen einer Vielzahl von Nadelrippen (125) in Öffnungen (250) einer ersten Platte (201) der Baugruppe zur Platzierung von Nadelrippen, wobei die Vielzahl von Nadelrippen (125) innerhalb Öffnungen (250) der ersten Platte der Baugruppe zur Platzierung von Nadelrippen durch die unter der ersten Platten (201) liegende zweite Platte (202) gehalten wird;
laterales Bewegen (1106) der zweiten Platte (202) relativ zu der ersten (201) und dritten (203) Platte, um ein Positionieren der Vielzahl von Nadelrippen (125) in den Öffnungen (250) der ersten Platte (201) innerhalb von Öffnungen (252) der dritten Platte (203) zu ermöglichen;
Positionieren (1108) der Nadelrippen (125) benachbart zu einer hinteren Fläche des IC-Chips (105) und Aufschmelzen eines zwischen den Nadelrippen (125) und dem IC-Chip (105) angeordneten Materials zum Bonden der Nadelrippen (125) an den IC-Chip (105), während die Nadelrippen (125) in Öffnungen (250) der dritten Platte (203) verbleiben, wodurch eine Vielzahl von Wärmeableitungselementen (120) an der Fläche des IC-Chips (105) gebildet wird.

15. Verfahren nach Anspruch 14, ferner umfassend Entfernen der Baugruppe zur Platzierung von Nadelrippen und Koppeln eines Verteilers (140) an den IC-Chip (105) und eine Leiterplatte, um den IC-Chip (105) zu umhüllen; oder
ferner umfassend Koppeln (1110) eines Verteilers (140) an den IC-Chip (105), während die Nadelrippen (125) innerhalb der Baugruppe zur Platzierung von Nadelrippen verbleiben; oder
wobei ein Abschnitt der Nadelrippen (125) innerhalb der Öffnungen (250) der dritten Platte (203) positioniert wird und ein Abschnitt der Nadelrippen (125) freigelegt wird, während die Nadelrippen (125) innerhalb der Baugruppe zur Platzierung von Nadelrippen verbleiben.

## Revendications

1. Ensemble pour positionner une pluralité d'éléments de dissipation thermique (120) sur une puce de circuit intégré, CI, (105) comprenant :
un ensemble de placement d'un élément de dissipation thermique comprenant :
un corps de plaque (577) comprenant une première plaque (501) et une deuxième plaque (503), la première plaque (501) présentant une première pluralité d'ouvertures (550) se prolongeant à travers les surfaces supérieure et inférieure de la première plaque (501) et la deuxième plaque (503) présentant une deuxième pluralité d'ouvertures (552) se prolongeant à travers les surfaces supérieure et inférieure de la deuxième plaque (503), chacune de la deuxième pluralité d'ouvertures (552) présentant un second diamètre qui est différent d'un premier diamètre de chacune de la première pluralité d'ouvertures (550), la deuxième pluralité d'ouvertures (552) étant alignées avec la première pluralité d'ouvertures (550), et
un ensemble de prise à vide (558) couplé de manière amovible à l'ensemble de placement d'un élément de dissipation thermique, l'ensemble de prise à vide (558) fournissant une force d'aspiration qui maintient la pluralité d'éléments de dissipation thermique (120) à l'intérieur de la première (550) ou de la deuxième pluralité d'ouvertures (552) dans le corps de plaque (577) et contre une surface du corps de plaque (577).

2. Ensemble selon la revendication 1, dans lequel l'ensemble de prise à vide (558) recouvre la puce de CI (105) et maintient les éléments de dissipation thermique (120) à l'intérieur de la première (550) ou la deuxième pluralité d'ouvertures (552), chacune des ouvertures de la première (550) ou de la deuxième pluralité d'ouvertures (552) de l'ensemble de placement d'un élément de dissipation thermique (558) étant alignée avec des connexions conductrices (124) disposées sur la puce de CI (105) ; ou
dans lequel la première plaque (501) recouvre la deuxième plaque (503), et le premier diamètre de la première pluralité d'ouvertures (550) est inférieur au second diamètre de la deuxième pluralité d'ouvertures (552), de sorte qu'une force créée par l'ensemble de prise à vide (558) maintient la pluralité d'éléments de dissipation thermique (120) à l'intérieur de la deuxième pluralité d'ouvertures (552) et contre une surface inférieure de la première plaque (501) ; ou
dans lequel la surface inférieure de la première plaque (501) est configurée pour entrer en contact avec des surfaces supérieures de la pluralité d'éléments de dissipation thermique (120), la surface inférieure de la première plaque (501) empêchant la pluralité d'éléments de dissipation thermique (120) d'être tirée dans la première pluralité d'ouvertures (550).

3. Ensemble selon la revendication 2, dans lequel la première plaque (501) recouvre la deuxième plaque (503) et le premier diamètre de la première pluralité d'ouvertures (550) est inférieur au second diamètre de la deuxième pluralité d'ouvertures (552), dans lequel la première (550) et la deuxième pluralité d'ouvertures (552) sont alignées et des surfaces inférieures de la première plaque (501) recouvrent au moins des parties de la deuxième pluralité d'ouvertures (552), la surface inférieure de la première plaque (501) étant configurée pour entrer en contact avec des surfaces supérieures de la pluralité d'éléments de dissipation thermique (120) dans la deuxième pluralité d'ouvertures (552) et pour empêcher les éléments de dissipation thermique (120) de se déplacer vers la première pluralité d'ouvertures (550).

4. Ensemble selon l'une des revendications 1 à 3, dans lequel l'ensemble de prise à vide (558) comprend également une pompe de prise à vide (559) et une chambre à vide (562) ; et
dans lequel la première plaque (501) recouvre éventuellement la deuxième plaque (503), et la chambre à vide (562) est couplée à la deuxième plaque (503).

5. Ensemble pour positionner des éléments de dissipation thermique (120) sur une puce de circuit intégré, CI, comprenant :
un ensemble de placement d'un élément de dissipation thermique (200) comprenant :
une plaque supérieure (201), une plaque intermédiaire (202), et une plaque inférieure (203) assemblées verticalement pour former un corps de plaque (277), dans lequel la plaque intermédiaire (202) est mobile par rapport à la plaque supérieure (201) et/ou à la plaque inférieure ;
une première pluralité d'ouvertures (250) formées dans la plaque supérieure (201) ; et
une deuxième pluralité d'ouvertures (252) formées dans la plaque inférieure, dans lequel la première (250) et la deuxième pluralité d'ouvertures (252) sont alignées verticalement, dans lequel la première (250) et la deuxième pluralité d'ouvertures (252) sont configurées pour recevoir les éléments de dissipation thermique (120) en leur sein, les éléments de dissipation thermique (120) étant configurés pour être disposés sur une puce de CI (105), et
un ensemble de prise à vide (258) couplé de manière amovible à l'ensemble de placement d'un élément de dissipation thermique (200), l'ensemble de prise à vide (258) étant configuré pour maintenir les éléments de dissipation thermique (120) contre au moins une partie du corps de plaque (277).

6. Ensemble selon la revendication 5, dans lequel l'ensemble de prise à vide (258) comprend également une pompe de prise à vide (259) et une chambre à vide (262) positionnée de manière adjacente à la plaque inférieure (203) ; ou
dans lequel la plaque intermédiaire (202) est positionnée entre la plaque supérieure (201) et la plaque inférieure (203), la plaque intermédiaire (202) étant mobile latéralement par rapport à la plaque supérieure (201) et/ou à la plaque inférieure (203) d'une première position de support d'élément de dissipation thermique à une seconde position de libération d'élément de dissipation thermique, dans lequel, dans la première position de support d'élément de dissipation thermique, la plaque intermédiaire (202) est configurée pour supporter les éléments de dissipation thermique (120) à l'intérieur de la première pluralité d'ouvertures (250).

7. Ensemble selon la revendication 6, dans lequel la plaque intermédiaire (202) comprend également une troisième pluralité d'ouvertures (254) formées dans la plaque intermédiaire (202), la troisième pluralité d'ouvertures (254) étant alignées verticalement avec la première (250) et la deuxième pluralité d'ouvertures (252) lorsque la plaque intermédiaire (202) est dans la première position de support de l'élément de dissipation thermique, et dans lequel, lorsque la plaque intermédiaire (202) est dans la position de libération de l'élément de dissipation thermique, la troisième pluralité d'ouvertures (254) ne s'alignent pas verticalement avec la première (250) et la deuxième pluralité d'ouvertures (252), un diamètre de la troisième pluralité d'ouvertures (254) étant inférieur à un diamètre de la première pluralité d'ouvertures (250).

8. Ensemble, comprenant :
une puce de circuit intégré, CI, (105) connectée électriquement à une carte de circuit imprimé, PCB (106) ;
un ensemble de placement d'un élément de dissipation thermique (800) couplé à la PCB (106), l'ensemble de placement d'un élément de dissipation thermique (800) comprenant un corps de plaque (877) présentant une surface supérieure (866), une surface inférieure (872), et une pluralité d'ouvertures (850) se prolongeant à travers les surfaces supérieure (866) et inférieure (872), dans lequel la pluralité d'ouvertures (850) présentent chacune un diamètre qui diminue en taille entre la surface inférieure (872) et la surface supérieure (866) ;
une pluralité d'éléments de dissipation thermique (120) disposés à l'intérieur de la pluralité d'ouvertures (850) et couplés à une surface de la puce de CI (105) ; et
un collecteur couplé au corps de plaque (877) et à la puce de CI (105), le collecteur étant configuré pour fournir une dissipation thermique de la puce de CI (105).

9. Ensemble selon la revendication 8, dans lequel l'ensemble de placement d'un élément de dissipation thermique (800) comprend également des supports de chambre de refroidissement (857) se prolongeant de l'ensemble de placement d'un élément de dissipation thermique (800) ; et
dans lequel des éléments de dissipation thermique (120) se prolongent éventuellement entre l'ensemble de placement d'un élément de dissipation thermique (800) et la puce de CI (105) ; ou
dans lequel le collecteur est éventuellement couplé à une surface arrière du corps de plaque et recouvre la puce de CI (105) ; ou
dans lequel les éléments de dissipation thermique sont éventuellement des éléments d'ailettes en broche (125), et une partie supérieure des éléments d'ailettes en broche est positionnée à l'intérieur des ouvertures (850) du corps de plaque (877) et une partie inférieure des éléments d'ailettes en broche est liée à la puce de CI (105).

10. Procédé pour fournir des éléments de dissipation thermique (120) sur une puce de circuit intégré, CI, (105), comprenant :
la fourniture (1002) d'un ensemble de placement d'un élément de dissipation thermique comprenant au moins une plaque et une pluralité d'ouvertures (250) se prolongeant à travers une surface supérieure et une surface inférieure de l'au moins une plaque ;
l'utilisation (1004) d'une aspiration sous vide créée par un ensemble de prise à vide (258) pour positionner et fixer de manière amovible les éléments de dissipation thermique (120) à l'intérieur de la pluralité d'ouvertures (250) ;
le raccordement (1006) des éléments de dissipation thermique (120) positionnés à l'intérieur de la pluralité d'ouvertures (250) avec une puce de CI (105) ; et
tandis que les éléments de dissipation thermique (120) sont positionnés à l'intérieur de l'ensemble de placement d'un élément de dissipation thermique, la refusion (1008) d'un matériau de liaison disposé entre les éléments de dissipation thermique (120) et la puce de CI (105) pour lier les éléments de dissipation thermique (120) à la puce de CI (105) ; ou
comprenant également le couplage (1010) d'un collecteur (140) à l'ensemble de placement d'un élément de dissipation thermique, le collecteur (140) comportant une entrée (127) et une sortie (128) configurées pour recevoir un matériau de refroidissement en leur sein, le collecteur (140) fournissant une dissipation thermique supplémentaire de la puce de CI (105) ; ou
comprenant également le retrait de l'ensemble de placement d'un élément de dissipation thermique et le couplage d'un collecteur (140) à la puce de CI (105), le collecteur (140) comprenant un plénum pour recevoir des matériaux de refroidissement en son sein ; et/ou
comprenant également éventuellement l'alimentation d'un fluide de refroidissement dans le plénum pour réguler une énergie thermique transmise de la puce de CI (105).

11. Procédé selon la revendication 10, dans lequel l'ensemble de placement d'un élément de dissipation thermique comprend une seule plaque, et dans lequel la pluralité d'ouvertures (250) présentent chacune un diamètre qui diminue en taille entre la surface supérieure et la surface inférieure ; ou
dans lequel l'au moins une plaque est une première plaque (201) et la pluralité d'ouvertures (250) est une première pluralité d'ouvertures (250), dans lequel l'ensemble de placement d'un élément de dissipation thermique comprend également une deuxième plaque présentant une deuxième pluralité d'ouvertures (250) alignées avec la première pluralité d'ouvertures (250), dans lequel la première pluralité d'ouvertures (250) de la première plaque est plus petite que la deuxième pluralité d'ouvertures (250) .

12. Procédé selon la revendication 11, dans lequel la première plaque recouvre la deuxième plaque, et dans lequel la force d'aspiration créée par l'ensemble de prise à vide (258) maintient les éléments de dissipation thermique (120) contre la surface inférieure de la première plaque.

13. Procédé selon l'une des revendications 10 à 12, dans lequel l'au moins une plaque est une première plaque et la pluralité d'ouvertures (250) est une première pluralité d'ouvertures (250), dans lequel l'ensemble de placement d'un élément de dissipation thermique comprend également une deuxième plaque positionnée sous la première plaque et présentant une deuxième pluralité d'ouvertures (250) alignées avec la première pluralité d'ouvertures (250), dans lequel la première pluralité d'ouvertures (250) est plus petite que la deuxième pluralité d'ouvertures (250), et dans lequel l'ensemble de prise à vide (258) attire les éléments de dissipation thermique (120) dans la deuxième pluralité d'ouvertures (250) ; ou
dans lequel l'au moins une plaque est une première plaque et la pluralité d'ouvertures (250) est une première pluralité d'ouvertures (250), dans lequel l'ensemble de placement d'un élément de dissipation thermique comprend également une deuxième plaque positionnée sous la première plaque et présentant une deuxième pluralité d'ouvertures (250) alignées avec la première pluralité d'ouvertures (250), dans lequel la première pluralité d'ouvertures (250) est plus grande que la deuxième pluralité d'ouvertures (250), et dans lequel l'ensemble de prise à vide (258) attire les éléments de dissipation thermique (120) dans la première pluralité d'ouvertures (250).

14. Procédé pour fournir des éléments de dissipation thermique (120) sur une puce de circuit intégré, CI, (105), comprenant :
la fourniture (1102) d'un ensemble de placement d'ailettes en broche avec un ensemble de prise à vide (258) couplé à celui-ci, l'ensemble de placement d'ailettes en broche comportant une première plaque (201), une deuxième plaque (202), et une troisième plaque (203) ;
l'utilisation (1104) d'une aspiration sous vide créée par un ensemble de prise à vide (258) pour tirer une pluralité d'ailettes en broche (125) dans des ouvertures (250) d'une première plaque (201) de l'ensemble de placement d'ailettes en broche, dans lequel la pluralité d'ailettes en broche (125) est supportée à l'intérieur des ouvertures (250) de la première plaque de l'ensemble de placement d'ailettes en broche par la deuxième plaque (202), qui se trouve sous la première plaque (201) ;
le déplacement latéral (1106) de la deuxième plaque (202) par rapport aux première (201) et troisième (203) plaques pour permettre à la pluralité d'ailettes en broche (125) dans les ouvertures (250) de la première plaque (201) d'être positionnées à l'intérieur des ouvertures (252) de la troisième plaque (203) ;
tandis que les ailettes en broche (125) restent à l'intérieur des ouvertures (250) de la troisième plaque (203), le positionnement (1108) des ailettes en broche (125) adjacentes à une surface arrière de la puce de CI (105) et la refusion d'un matériau disposé entre les ailettes en broche (125) et la puce de CI (105) pour lier les ailettes en broche (125) à la puce de CI (105), formant ainsi une pluralité d'éléments de dissipation thermique (120) au niveau de la surface de la puce de CI (105).

15. Procédé selon la revendication 14, comprenant également le retrait de l'ensemble de placement d'ailettes en broche et le couplage d'un collecteur (140) avec la puce de CI (105) et une carte de circuit imprimé pour enfermer la puce de CI (105) ; ou comprenant également le couplage (1110) d'un collecteur (140) avec la puce de CI (105) tandis que les ailettes en broche (125) restent à l'intérieur de l'ensemble de placement d'ailettes en broche ; ou
dans lequel, tandis que les ailettes en broche (125) restent à l'intérieur de l'ensemble de placement d'ailettes en broche, une partie des ailettes en broche (125) sont positionnées à l'intérieur des ouvertures (250) de la troisième plaque (203) et une partie des ailettes en broche (125) sont exposées.
